# EUROPÄISCHE PATENTANMELDUNG

(11) **EP 4 841 335 A2**
(43) Veröffentlichungstag der Anmeldung: **18.11.2026**
(21) Anmeldenummer: 26206086.6
(22) Anmeldetag: 23.02.2021
(51) Int. Cl.: G02F 1/13

(54) **PHOTODETEKTOR, MODULATOR, HALBLEITEREINRICHTUNG UND HALBLEITERVORRICHTUNG**

(30) Priorität: 09.03.2020 DE 202020101285 U
(62) Dokumentnummer(n) der früheren Anmeldung(en) nach Art. 76 EPÜ: 21709626.2 / 4 118 486
(71) Anmelder: Black Semiconductor GmbH, 52068 Aachen (DE)
(72) Erfinder: Schall, Daniel, 40667 Meerbusch (DE)
(74) Vertreter: Paul & Albrecht Patentanwälte PartG mbB

(57) **Zusammenfassung**

Die vorliegende Erfindung betrifft einen Photodetektor (3) umfassend einen Längsabschnitt (12) eines Wellenleiters (11), der zwei sich in Längsrichtung und zumindest im Wesentlichen parallel zueinander erstreckende Wellenleitersegmente (12a, 12b), die bevorzugt in Querrichtung unter Bildung eines sich zwischen ihnen erstreckenden Spaltes (14) voneinander beabstandet sind, umfasst oder dadurch gebildet wird, und ein aktives Element (13), welches den Längsabschnitt (12) des Wellenleiters übergreift und wenigsten ein Material umfasst oder aus wenigstens einem Material besteht, das elektromagnetische Strahlung wenigstens einer Wellenlänge absorbiert und infolge der Absorption ein elektrisches Photosignal erzeugt, wobei die beiden Wellenleitersegmente (12a, 12b) jeweils an wenigstens einer Seite, insbesondere an der dem aktiven Element (14) zugewandten Seite zumindest abschnittsweise mit einer bevorzugt Silizium umfassenden oder aus Silizium bestehenden Gateelektrode (15a, 15b) in Kontakt stehen.

## Beschreibung

Die Erfindung betrifft einen Photodetektor und einen Modulator. Darüber hinaus betrifft die Erfindung eine Halbleitereinrichtung mit einem Chip und wenigstens einem Photodetektor und/oder Modulator sowie eine Halbleitervorrichtung mit einem Wafer und wenigstens einem Photodetektor und/oder Modulator.

Es sind elektro-optische Einrichtungen, beispielsweise Photodetektoren oder elektro-optische Modulatoren aus dem Stand der Technik vorbekannt, die einen Wellenleiter bzw. Längsabschnitt eines solchen mit mehreren sich in Längsrichtung und zumindest im Wesentlichen parallel zueinander erstreckende Wellenleitersegmenten und - im Falle eines Photodetektors - einen bzw. - im Falle eines elektro-optischen Modulators - zwei Filme aus Graphen als aktive Elemente umfassen. Solche sind beispielsweise in der US 9,893,219 B2 offenbart.

Die bekannten Photodetektoren und Modulatoren haben sich prinzipiell bewährt. Es besteht jedoch Bedarf an weiteren, alternativ gestalteten Photodetektoren und Modulatoren, die sich mit vertretbarem Aufwand fertigen lassen und sich durch eine optimale Funktionsweise auszeichnen.

Es ist daher eine Aufgabe der vorliegenden Erfindung, alternativ gestaltete Photodetektoren und Modulatoren anzugeben, welche diese Anforderungen erfüllen.

Diese Aufgabe wird hinsichtlich eines Photodetektors mit den in den Ansprüchen 1 und 6 genannten Maßnahmen sowie hinsichtlich eines Modulator mit den in den Ansprüchen 9, 10 und 11 genannten Maßnahmen gelöst.

Gemäß einem ersten Aspekt der Erfindung wird ein Photodetektor bereitgestellt, der einen Längsabschnitt eines Wellenleiters, der zwei sich in Längsrichtung und zumindest im Wesentlichen parallel zueinander erstreckende Wellenleitersegmente, die insbesondere in Querrichtung unter Bildung eines sich zwischen ihnen erstreckenden Spaltes voneinander beabstandet sind, umfasst oder dadurch gebildet wird, und ein aktives Element, welches den Längsabschnitt des Wellenleiters übergreift und wenigsten ein Material umfasst oder aus wenigstens einem Material besteht, das elektromagnetische Strahlung wenigstens einer Wellenlänge absorbiert und infolge der Absorption ein elektrisches Photosignal erzeugt, wobei die beiden Wellenleitersegmente jeweils an wenigstens einer Seite, insbesondere an der dem aktiven Element zugewandten Seite zumindest abschnittsweise mit einer bevorzugt Silizium umfassenden oder aus Silizium bestehenden Gateelektrode in Kontakt stehen, umfasst.

Ein erfindungsgemäßes Verfahren zur Herstellung eines solchen Detektors umfasst beispielsweise, dass ein Wellenleitermaterial insbesondere auf einen Wafer oder auf eine auf oder oberhalb eines Wafers vorgesehene Schicht aufgebracht, bevorzugt abgeschieden wird, und ein Gateelektrodenmaterial, bevorzugt Silizium, aufgebracht, insbesondere abgeschieden wird, und eine Strukturierung erfolgt, um die beiden Wellenleitersegmente mit dem dazwischenliegenden Spalt und die Gateelektroden zu erhalten, und das aktive Element vorgesehen wird.

Mittels der Gateelektroden kann im Betrieb ein pn-Übergang in dem aktiven Element realisiert werden. Durch die Anordnung des pn-Übergangs im Bereich der optischen Mode wird ein optimaler Überlapp zwischen dem absorbierenden Material und dem aktiven Bereich des Photodetektors erreicht.

In vorteilhafter Ausgestaltung ist dabei vorgesehen, dass die Gateelektroden jeweils an ihrer Unterseite mit der Oberseite eines Wellenleitersegmentes und mit ihrer Oberseite mit der Unterseite einer zwischen dem aktiven Element und den Wellenleitersegmenten vorgesehenen dielektrischen Schicht, die zweckmäßiger Weise wenigstens ein dielektrisches Material umfasst oder aus wenigstens einem dielektrischen Material besteht, in Kontakt stehen. Als geeignete Materialien haben sich beispielsweise Siliziumdioxid (SiO₂) sowie Aluminiumoxid (AL₂O₃) erwiesen. Alternativ zu dem Ausdruck dielektrisches Material wird auch der Begriff Dielektrikum verwendet. Die dielektrische Schicht kann auch als Gatedielektrikum bezeichnet werden.

Das aktive Element kann in Weiterbildung auf der Oberseite der dielektrischen Schicht angeordnet sein bzw. werden. Es kann darauf hergestellt worden sein bzw. werden.

Die dielektrische Schicht kann sich in bevorzugter Ausgestaltung an ihrer Oberseite durch eine Rauheit im Bereich von 1,0 nm RMS bis 0,1 nm RMS, insbesondere 0,6 nm RMS bis 0,1 nm RMS, bevorzugt 0,4 nm RMS bis 0,1 nm RMS aus zeichnen. Die Abkürzung RMS steht für root mean squared. Die RMS-Rauheit wird im Deutschen auch als quadratische Rauheit bezeichnet. Eine Oberseite mit einer Rauheit in diesem Bereich hat sich insbesondere in demjenigen Falle als besonders geeignet erwiesen, dass das aktive Element auf der Oberseite der dielektrischen Schicht vorgesehen, insbesondere darauf hergestellt wird.

Die Dicke der dielektrischen Schicht kann beispielsweise im Bereich von 10 bis 20 nm liegen.

Die Gateelektroden umfassen bevorzugt ein für elektromagnetische Strahlung wenigstens einer Wellenlänge, bevorzugt wenigstens eines Wellenlängenbereichs, transparentes und/oder elektrisch leitfähiges Material oder bestehen daraus.

Weiter bevorzugt umfassen die Gateelektroden wenigstens ein Material, das für elektromagnetische Strahlung einer Wellenlänge von 850 nm und/oder 1310 nm und/oder 1550 nm transparent ist oder besteht aus einem solchen. Besonders bevorzugt ist es für elektromagnetische Strahlung im Wellenlängenbereich von 800 nm bis 900 nm und/oder von 1260 nm bis 1360 nm (sogenanntes Original Band bzw. kurz O-Band) und/oder 1360 nm bis 1460 nm (sogenanntes Extend Band oder kurz E-Band) und/oder 1460 nm bis 1530 nm (sogenanntes Short Band oder kurz S-Band) und/oder von 1530 nm bis 1565 nm (sogenanntes Conventional Band bzw. kurz C-Band) und/oder 1565 nm bis 1625 nm (sogenanntes Long Band bzw. kurz L-Band) transparent. Diese Bänder sind aus dem Bereich der Nachrichtentechnik vorbekannt.

Dies gilt entsprechend bevorzugt für das Gateelektrodenmaterial, das im Rahmen des Herstellungsverfahrens verwendet wird.

Als ganz besonders geeignetes Material für die Gateelektroden hat sich Silizium erwiesen. Es kann sich um Polysilizium. Indiumzinnoxid (ITO) kommt auch in Frage. Das Material bzw. die Materialien, aus denen die Gateelektroden bestehen bzw. hergestellt werden kann ferner dotiert sein.

Die jeweilige Gateelektrode kann beispielsweise eine auf der dem aktiven Element zugewandten Seite des jeweiligen Wellenleitersegmentes des Wellenleiterlängsabschnitts vorgesehene Schicht sein, besonders bevorzugt eine Schicht, die auf dem jeweiligen Wellenleitersegment hergestellt wird bzw. wurde.

Darüber hinaus kann vorgesehen sein, dass die Gateelektroden durch Abscheidung, insbesondere chemische Gasphasenabscheidung (englisch: chemical vapor deposition, kurz CVD), bevorzugt Niederdruck chemische Gasphasenabscheidung (englisch: low pressure chemical vapor deposition, kurz: LPCVD) und/oder plasmaunterstütze chemische Gasphasenabscheidung (englisch plasma enhanced chemical vapor deposition, kurz: PECVD), und/ oder durch physikalische Gasphasenabscheidung (englisch: physical vapor deposition, kurz: PVD) eines Beschichtungsmaterials hergestellt worden sind bzw. hergestellt werden.

Es gibt unterschiedliche aus dem Stand der Technik vorbekannte Verfahren der chemischen Gasphasenabscheidung, die allesamt im Rahmen der vorliegenden Erfindung zum Einsatz gekommen sein bzw. kommen können. Allen gemein ist in der Regel eine chemische Reaktion von eingeleiteten Gasen, die zu einer Abscheidung des gewünschten Materials führen.

Auch bezüglich der physikalischen Gasphasenabscheidung gilt, dass alle aus dem Stand der Technik vorbekannten Varianten zum Einsatz gekommen sein bzw. kommen können. Rein beispielhaft sei das Elektronenstrahlverdampfen genannt, bei dem mittels eines Elektronenstrahls Material geschmolzen und verdampft wird, sowie das thermische Verdampfen, bei dem Material mittels einer Heizung bis zum Schmelzpunkt erwärmt und auf ein Zielsubstrat gedampft wird, sowie die Kathodenzerstäubung (englisch: sputter deposition), bei der mittels eines Plasmas Atome aus einem Materialträger herausgeschlagen und auf einem Zielsubstrat abgeschieden werden.

Alternativ oder zusätzlich zu den vorgenannten Abscheidungsverfahren kommt auch die Atomlagenabscheidung (englisch: atomic layer deposoition, kurz: ALD) in Frage, um die bzw. die jeweilige Gateelektrode zu erhalten. Im Rahmen dieser werden isolierende oder leitende Materialien (Dielektrika, Halbleiter oder Metalle) Atomlage für Atomlage sequenziell abgeschieden. Auch ein Transferverfahren kann zur Anwendung kommen bzw. gekommen sein.

In Weiterbildung kann ferner vorgesehen sein, dass jeder der beiden Gateelektroden ein mit dieser in Kontakt stehendes Verbindungselement zugeordnet ist und sich bevorzugt jeweils eines der Verbindungselemente durch eines der Wellenleitersegmente erstreckt. An die Abscheidung kann sich ein geeignetes Strukturierungsverfahren schließen bzw. angeschlossen haben, das beispielsweise Lithografie und/oder Ätzen einschließen kann. Bei den Verbindungselementen handelt es sich bevorzugt um vertikale elektrische Verbindungen, die im Englischen auch als Vertical Interconnect Access, kurz Via bzw. VIA, bezeichnet werden. VIAs werden in der Regel durch Lithografie definiert und insbesondere mittels reaktivem Ionenätzen (kurz: RIE) trockenchemisch geätzt. Danach wird bevorzugt metallisiert und die metallisierte Oberfläche mittels CMP (Damascene-Prozess) oder mittels Lithografie und RIE strukturiert.

Das reaktive Ionenätzen ist ein Trockenätzverfahren, bei dem in der Regel mittels spezieller gasförmiger Chemikalien, die zu einem Plasma angeregt werden, ein selektives und gerichtetes Ätzen einer Substratoberfläche ermöglicht wird. Eine Lackmaske kann dabei nicht zu ätzende Teile schützen. Die Ätzchemie und die Parameter des Prozesses entscheiden in der Regel über die Selektivität des Prozesses, also die Ätzraten unterschiedlicher Materialien. Diese Eigenschaft ist entscheidend, um einen Ätzvorgang in der Tiefe zu begrenzen und damit Schichten voneinander getrennt zu definieren.

Die Verbindungselemente umfassen bzw. bestehen zweckmäßiger Weise aus wenigstens einem elektrisch leitenden Material, insbesondere Metall, wie etwa Kupfer und/oder Aluminium und/oder Wolfram.

In weiterer vorteilhafter Ausführungsform ist ferner vorgesehen, dass das aktive Element die beiden Wellenleitersegmente und den dazwischenliegenden Spalt zumindest abschnittsweise übergreift, dies insbesondere in Querrichtung. Unter Querrichtung ist zweckmäßiger Weise die orthogonal zur Längsrichtung des Längsabschnitts des Wellenleiters orientierte Richtung zu verstehen.

Gemäß einem zweiten Aspekt der Erfindung wird ein Photodetektor bereitgestellt, der einen Längsabschnitt eines Wellenleiters, und ein aktives Element umfasst, welches wenigsten ein Material umfasst oder aus wenigstens einem Material besteht, das elektromagnetische Strahlung wenigstens einer Wellenlänge absorbiert und infolge der Absorption ein elektrisches Photosignal erzeugt, wobei zwei Trageelemente an gegenüberliegenden Seiten des Längsabschnitts des Wellenleiters unter Bildung zweier Spalte von diesem beabstandet angeordnet sind, wobei die beiden Spalte frei von Material sind, und wobei das aktive Element den Längsabschnitt des Wellenleiters und die beiden Spalte und zumindest Abschnitte der beiden Tragelemente insbesondere in Querrichtung übergreift. Die beiden Trageelemente sind bevorzugt in Querrichtung beabstandet von dem Längsabschnitt angeordnet.

Ein erfindungsgemäßes Verfahren zur Herstellung eines solchen Detektors umfasst beispielsweise, dass ein Wellenleitermaterial insbesondere auf einen Wafer oder auf eine auf oder oberhalb eines Wafers vorgesehene Schicht aufgebracht, bevorzugt abgeschieden wird und eine Strukturierung erfolgt, um die beiden Spalte und den Längsabschnitt des Wellenleiters und die Tragelemente zu erhalten, und das aktive Element oberhalb des Längsabschnitts des Wellenleiters und der Tragelemente vorgesehen wird.

Die Spalte, die frei von Material sind, sind insbesondere durch Bereiche gegeben, aus denen durch einen Ätzprozess Material entfernt und anschließend kein neues Material vorgesehen, etwa abgeschieden wurde. Sie können mit Luft oder auch einem anderen Gas gefüllt sein oder unter Vakuum stehen. Es befindet sich jedoch kein festes Material in diesen. Unter Vakuum ist bevorzugt ein beispielsweise durch Abpumpen evakuierter Raum zu verstehen.

In bevorzugter Ausgestaltung gilt, dass das aktive Element auf der diesem zugewandten Oberseite des Längsabschnitts des Wellenleiters und/oder auf den diesem zugewandten Oberseiten der Tragelemente aufliegt.

Die Tragelemente können aus dem gleichen Material bestehen, wie der Längsabschnitt des Wellenleiters, wobei dies beispielhaft zu verstehen ist. Als geeignete Materialien für die Tragelemente haben sich beispielsweise TiO₂ und/oder Si erwiesen. Es kommen auch alle anderen Materialien in Frage, die für Wellenleiter geeignet sind.

Es kann sein, dass das aktive Element wenigstens ein Material umfasst oder aus wenigstens einem Material besteht, das elektromagnetische Strahlung einer Wellenlänge von 850 nm und/oder 1310 nm und/oder 1550 nm absorbieren und infolge der Absorption ein Photosignal erzeugen kann. Besonders bevorzugt gilt, dass es elektromagnetische Strahlung im Wellenlängenbereich von 800 nm bis 900 nm und/oder von 1260 nm bis 1360 nm (sogenanntes Original Band bzw. kurz O-Band) und/oder 1360 nm bis 1460 nm (sogenanntes Extended Band oder kurz E-Band) und/oder 1460 nm bis 1530 nm (sogenanntes Short Band oder kurz S-Band) und/oder von 1530 nm bis 1565 nm (sogenanntes Conventional Band bzw. kurz C-Band) und/oder 1565 nm bis 1625 nm (sogenanntes Long Band bzw. kurz L-Band) absorbieren und infolge der Absorption ein Photosignal erzeugen kann.

Es hat sich als ganz besonders geeignet erwiesen, wenn es sich bei dem wenigstens einen Material des aktiven Elementes, das elektromagnetische Strahlung wenigstens einer Wellenlänge absorbiert und infolge der Absorption ein elektrisches Photosignal erzeugt, um Graphen, und/oder wenigstens ein Dichalkogenid, insbesondere zweidimensionales Übergangsmetall-Dichalkogenid, und/oder Heterostrukturen aus zweidimensionalen Materialien und/oder Germanium und/oder wenigstens ein elektro-optisches Polymer und/oder Silizium und/oder wenigstens einen Verbindungshalbleiter, insbesondere wenigsten einen III-V-Halbleiter und/oder wenigstens einen II-VI-Halbleiter, handelt.

Ein Photodetektor kann insbesondere der Signalwandlung zurück von der optischen in die elektronische Welt dienen.

Gemäß einem dritten Aspekt der Erfindung wird ein insbesondere elektro-optischer Modulator bereitgestellt, der einen Längsabschnitt eines Wellenleiters, der vier sich in Längsrichtung und zumindest im Wesentlichen parallel zueinander erstreckende Wellenleitersegmente umfasst oder durch diese gebildet wird, und zwei aktive Elemente, die wenigsten ein Material umfassen oder aus wenigstens einem Material bestehen, dessen Brechungsindex sich in Abhängigkeit einer Spannung und/oder dem Vorhandensein von Ladung und/oder einem elektrischen Feld ändert, oder ein solches aktives Element und eine Elektrode, umfasst, wobei ein unteres der Wellenleitersegmente zwischen den beiden aktiven Elemente oder zwischen dem aktiven Element und der Elektrode angeordnet ist, ein mittleres der Wellenleitersegmente oberhalb der beiden aktiven Elemente oder oberhalb des aktiven Elementes und der Elektrode angeordnet ist, und die beiden verbleibenden, oberen Wellenleitersegmente oberhalb des mittleren Wellenleitersegmentes angeordnet sind, wobei die beiden oberen Wellenleitersegmente bevorzugt in Querrichtung unter Bildung eines sich zwischen ihnen erstreckenden Spaltes voneinander beabstandet sind, umfasst.

Dann kann insbesondere ein sandwichartiger Aufbau vorliegen, der - von unten nach oben - ein aktives Element oder die Elektrode, dann das unterer Wellenleitersegment des Längsabschnitts des Wellenleiters, dann das zweite aktive Element oder die Elektrode, dann das mittlere Wellenleitersegment des Längsabschnitts des Wellenleiters und dann die beiden oberen Segmente des Längsabschnitts des Wellenleiters umfasst.

Ein erfindungsgemäßes Verfahren zur Herstellung eines solchen Modulators umfasst beispielsweise, dass ein aktives Element oder eine Elektrode insbesondere auf einem Wafer oder auf einer auf oder oberhalb eines Wafers vorgesehenen Schicht vorgesehen wird, und ein Wellenleitermaterial aufgebracht, bevorzugt abgeschieden wird, um das untere Wellenleitersegment zu erhalten, und das weitere aktive Element oder eine Elektrode oberhalb des unteren Wellenleitersegmentes vorgesehen wird, und ein Wellenleitermaterial aufgebracht, bevorzugt abgeschieden wird, um das mittlere Wellenleitersegment zu erhalten, und ein Wellenleitermaterial aufgebracht, bevorzugt abgeschieden wird und eine anschließende Strukturierung erfolgt, um die beiden oberen Wellenleitersegmente und den dazwischenliegenden Spalt zu erhalten.

Dass ein Element bzw. Segment oder auch eine Schicht oberhalb oder unterhalb eines anderen Elementes oder Segmentes oder einer anderen Schicht angeordnet ist (dass es mit anderen Worten über oder unter einem anderen Element oder Segment oder einer anderen Schicht angeordnet ist) umfasst sowohl, dass es sich direkt auf bzw. direkt unter dem anderen Element bzw. Segment oder auch der anderen Schicht befindet, und mit diesem bzw. dieser, etwa mit der Ober- oder Unterseite des anderen Elementes oder Segmentes oder der anderen Schicht in Kontakt steht, diese also berührt, oder auch, dass noch wenigstens ein weiteres Element oder Segment oder wenigstens eine weitere Schicht (ober- oder auch unterseitig) dazwischen liegt. Dies gilt für die Photodetektoren und Modulatoren nach allen Aspekten der Erfindung.

Nach einem vierten Aspekt der Erfindung wird ein insbesondere elektro-optischer Modulator umfassend einen Längsabschnitt eines Wellenleiters, der vier sich in Längsrichtung und zumindest im Wesentlichen parallel zueinander erstreckende Wellenleitersegmente umfasst oder durch diese gebildet wird, und zwei aktive Elemente, die wenigsten ein Material umfassen oder aus wenigstens einem Material bestehen, dessen Brechungsindex sich in Abhängigkeit einer Spannung und/oder dem Vorhandensein von Ladung und/oder einem elektrischen Feld ändert, oder ein solches aktives Element und eine Elektrode, wobei zwei untere der Wellenleitersegmente unterhalb der aktiven Elemente oder unterhalb des aktiven Elementes und der Elektrode angeordnet und bevorzugt in Querrichtung unter Bildung eines sich zwischen ihnen erstreckenden Spaltes voneinander beabstandet sind, und ein erstes mittleres der Wellenleitersegmente zwischen den beiden aktiven Elementen oder zwischen dem aktiven Element und der Elektrode angeordnet ist, und ein zweites mittleres Wellenleitersegment oberhalb der beiden aktiven Elemente oder oberhalb des aktiven Elementes und der Elektrode angeordnet ist, und ein oberes Wellenleitersegment oberhalb des zweiten mittleren Wellenleitersegments angeordnet ist, bereitgestellt.

Das obere Wellenleitersegment hat bevorzugter Weise eine Ausdehnung in Querrichtung, welche die Ausdehnung der weiteren Wellenleitersegmente ein Querrichtung unterschreitet. Es kann sein, dass die Ausdehnung des beiden unteren und der beiden mittleren Segmente in Querrichtung ein Mehrfaches von der Ausdehnung des oberen Segmentes in dieser Richtung beträgt.

Ein erfindungsgemäßes Verfahren zur Herstellung eines solchen Modulators umfasst beispielsweise, dass ein Wellenleitermaterial insbesondere auf einen Wafer oder auf eine auf oder oberhalb eines Wafers vorgesehene Schicht aufgebracht, bevorzugt abgeschieden wird und eine Strukturierung erfolgt, um die beiden unteren Wellenleitersegmente und den dazwischen liegenden Spalt zu erhalten und oberhalb dieser ein aktives Element oder eine Elektrode vorgesehen wird, und ein Wellenleitermaterial aufgebracht, bevorzugt abgeschieden wird, um das erste mittlere Wellenleitersegment zu erhalten, und das weitere aktive Element oder eine Elektrode oberhalb des ersten mittleren Wellenleitersegmentes vorgesehen wird, und ein Wellenleitermaterial aufgebracht, bevorzugt abgeschieden wird, um das zweite mittlere Wellenleitersegment zu erhalten, und ein Wellenleitermaterial aufgebracht, bevorzugt abgeschieden wird und bevorzugt eine anschließende Strukturierung erfolgt, um das obere Wellenleitersegment zu erhalten.

Nach einem fünften Aspekt der Erfindung wird ein insbesondere elektro-optischer Modulator umfassend einen Längsabschnitt eines Wellenleiters, der sechs sich in Längsrichtung und zumindest im Wesentlichen parallel zueinander erstreckende Wellenleitersegmente umfasst oder durch diese gebildet wird, und zwei aktive Elemente, die wenigsten ein Material umfassen oder aus wenigstens einem Material bestehen, dessen Brechungsindex sich in Abhängigkeit einer Spannung und/oder dem Vorhandensein von Ladung und/oder einem elektrischen Feld ändert, oder ein solches aktives Element und eine Elektrode, wobei zwei untere der Wellenleitersegmente unterhalb der aktiven Elemente oder unterhalb des aktiven Elementes und der Elektrode angeordnet und bevorzugt in Querrichtung unter Bildung eines sich zwischen ihnen erstreckenden Spaltes voneinander beabstandet sind, und ein erstes mittleres der Wellenleitersegmente zwischen den beiden aktiven Elementen oder zwischen dem aktiven Element und der Elektrode angeordnet ist, und ein zweites mittleres Wellenleitersegment oberhalb der beiden aktiven Elemente oder oberhalb des aktiven Elementes und der Elektrode angeordnet ist, und die beiden verbleibenden, oberen Wellenleitersegmente oberhalb des zweiten mittleren Wellenleitersegmentes angeordnet sind, wobei die beiden oberen Wellenleitersegmente bevorzugt in Querrichtung unter Bildung eines sich zwischen ihnen erstreckenden Spaltes voneinander beabstandet sind, bereitgestellt.

Ein erfindungsgemäßes Verfahren zur Herstellung eines solchen Modulators umfasst beispielsweise, dass ein Wellenleitermaterial insbesondere auf einen Wafer oder auf eine auf oder oberhalb eines Wafers vorgesehene Schicht aufgebracht, bevorzugt abgeschieden wird und eine Strukturierung erfolgt, um die beiden unteren Wellenleitersegmente und den dazwischen liegenden Spalt zu erhalten und oberhalb dieser ein aktives Element oder eine Elektrode vorgesehen wird, und ein Wellenleitermaterial aufgebracht, bevorzugt abgeschieden wird, um das erste mittlere Wellenleitersegment zu erhalten, und das weitere aktive Element oder eine Elektrode oberhalb des ersten mittleren Wellenleitersegmentes vorgesehen wird, und ein Wellenleitermaterial aufgebracht, bevorzugt abgeschieden wird, um das zweite mittlere Wellenleitersegment zu erhalten, und ein Wellenleitermaterial aufgebracht, bevorzugt abgeschieden wird und eine anschließende Strukturierung erfolgt, um die beiden obere Wellenleitersegmente und den dazwischenliegenden Spalt zu erhalten.

Ein elektro-optischer Modulator kann insbesondere zur optischen Signalcodierung verwendet werden. Ein elektro-optischer Modulator kann auch als Ringmodulator ausgebildet sein.

Im Falle eines Modulators, der zwei aktive Elemente umfasst gilt weiter bevorzugt, dass die beiden aktiven Elemente voneinander beabstandet und derart versetzt zueinander angeordnet sind bzw. werden, dass sie in einem Überlappungsbereich abschnittsweise übereinander liegen. Umfasst ein Modulator nur ein aktives Element und eine (konventionelle) Elektrode, kann analog in bevorzugter Ausgestaltung gelten, dass das aktive Element und die Elektrode voneinander beabstandet und derart versetzt zueinander angeordnet sind bzw. werden, dass sie in einem Überlappungsbereich abschnittsweise übereinander liegen.

Mit anderen Worten fluchtet bzw. überlappt dann ein Abschnitt des einen aktiven Elementes mit einem Abschnitt des anderen aktiven Elementes bzw. der Elektrode, dies zweckmäßiger Weise ohne, dass sich diese berühren. Bevorzugt gilt zumindest im Bereich des Übereinanderliegens, mit anderen Worten im Überlappungsbereich, dass sich die beiden aktiven Elemente bzw. das aktive Element und die Elektrode bzw. zumindest Abschnitte dieser zumindest im Wesentlichen parallel zueinander erstrecken.

Der Überlappungsbereich liegt besonders bevorzugt oberhalb oder unterhalb des Spaltes bzw. wird dort vorgesehen. Er fluchtet insbesondere mit diesem. Die optische Mode kann dann im Schlitz zwischen den beiden Wellenleitersegmenten mit hoher elektrischer Feldstärke geführt werden (Schlitzmode, engl. slot mode). An den Randbereichen oberhalb und unterhalb des Schlitzes befindet sich ein Teil der optischen Mode außerhalb des Schlitzes. In diesen Bereichen kann die optische Mode besonders effizient mit einem aktiven optischen Material wechselwirken.

Sind zwei Spalte vorhanden gilt insbesondere, dass der Überlappungsbereich oberhalb des einen und unterhalb des anderen Spaltes liegt bzw. vorgesehen wird. Die beiden Spalte und der Überlappungsbereich bzw. ein Abschnitt von diesem können fluchten, was sich als besonders geeignet erwiesen hat. Durch die beiden übereinander angeordneten Spalte befindet sich im Bereich zwischen den Spalten ein besonders hoher Anteil der optischen Mode, insbesondere im Vergleich zu einer Anordnung mit nur einem Spalt, wodurch eine besonders effiziente Wechselwirkung mit einem elektrooptischen Material ermöglicht wird.

In Weiterbildung ist bzw. wird oberhalb der beiden aktiven Elemente oder oberhalb des aktiven Elementes und der Elektrode genau ein zwischen zwei beabstandet Wellenleitersegmenten gebildeter Spalt vorgesehen. Alternativ oder zusätzlich kann unterhalb der beiden aktiven Elemente oder unterhalb des aktiven Elementes und der Elektrode genau ein zwischen zwei beabstandeten Wellenleitersegmenten gebildeter Spalt vorgesehen sein bzw. werden.

Die Ausdehnung des Überlappungsbereiches in Querrichtung entspricht in weiterer besonders vorteilhafter Ausgestaltung im Bereich vom 0,8-fachen bis 1,8-fachen, bevorzugt 1,0-fachen bis 1,5-fachen der Ausdehnung des oder wenigstens eines der Spalte in Querrichtung.

Darunter, dass ein Material seinen Brechungsindex ändert ist insbesondere zu verstehen, dass es seine Dispersion (insbesondere Brechzahl) und/oder seine Absorption ändert. Die Dispersion bzw. Brechzahl ist in der Regel durch den Realteil und die Absorption durch den Imaginärteil des komplexen Brechungsindexes gegeben. Unter Materialien, deren Brechungsindex sich in Abhängigkeit einer Spannung und/oder dem Vorhandensein von Ladung(en) und/oder einem elektrischen Feld ändert, sind vorliegend insbesondere solche zu verstehen, die sich durch den Pockels-Effekt und/oder den Franz-Keldysh-Effekt und/oder den Kerr-Effekt auszeichnen. Darüber hinaus werden auch Materialien, die sich durch den Plasmadispersions-Effekt auszeichnen vorliegend als solche Materialien erachtet.

Es hat sich als besonders geeignet erwiesen, wenn es sich bei dem wenigstens einen Material wenigstens eines der aktiven Elemente, dessen Brechungsindex sich in Abhängigkeit einer Spannung und/oder dem Vorhandensein von Ladung und/oder einem elektrischen Feld ändert, um Graphen, ggf. chemisch modifiziertes Graphen, und/oder wenigstens ein Dichalkogenid, insbesondere zweidimensionales Übergangsmetall-Dichalkogenid, und/oder Heterostrukturen aus zweidimensionalen Materialien und/oder Germanium und/oder Lithiumniobat und/oder wenigstens ein elektro-optisches Polymer und/oder Silizium und/oder wenigstens einen Verbindungshalbleiter, insbesondere wenigsten einen III-V-Halbleiter und/oder wenigstens einen II-VI-Halbleiter, handelt.

Als ganz besonders geeignetes Material für das bzw. die aktiven Elemente hat sich - für alle fünf Aspekte der Erfindung - Graphen erwiesen.

Unter elektro-optischen Polymeren sind insbesondere Polymere zu verstehen, die sich dadurch auszeichnen, dass sie einen starken linearen elektro-optischen Koeffizienten (Pockels-Effekt) haben. Unter einem starken linearen elektro-optischen Koeffizienten ist bevorzugt ein solcher zu verstehen, der mindestens 150 pm/V, bevorzugt mindestens 250 pm/V beträgt. Dann ist der elektro-optische Koeffizient mindestens etwa fünfmal so groß wie derjenige von Lithiumniobad.

Es gibt unterschiedliche Chalkogenide. Im Rahmen der vorliegenden Erfindung haben sich insbesondere Übergangsmetall-Dichalkogenide als zweidimensionale Materialien, wie MoS2 oder WSe2, als besonders geeignet erwiesen.

Es sei angemerkt, dass Lithiumniobat und elektro-optische Polymere auf dem elektro-optischen, insbesondere dem Pockels-Effekt basieren, d.h. das E-Feld ändert den Brechungsindex (wie z.B. der Pockels-Effekt in der Pockelszelle genutzt wird). Bei Germanium ist es der Franz-Keldysh-Effekt, d.h. das Feld verschiebt die Valenz und Leitungsbandkanten gegeneinander, so dass sich die optischen Eigenschaften ändern. Diese Effekte sind feldbasierte Effekte. Bei Silizium oder Graphen ist es der ladungsträgerbasierte Plasmadispersions-Effekt, d.h. Ladungsträger (Elektronen oder Löcher) werden in den Bereich der optischen Mode gebracht (entweder befindet sich in der Anordnung ein Kondensator, der aufgeladen wird, oder eine Diode mit einer Sperrschicht, die verarmt und angereichert wird). Der Brechungsindex (Realteil vom Index) und die Absorption (Imaginärteil des Indexes, führt zu free carrier absorption) ändern sich mit der Ladungsträgerkonzentration.

Bei III-V-Halbleitern bzw. handelt es sich in an sich bekannter Weise um Verbindungshalbleiter, die aus Elementen der Hauptgruppe III und V bestehen. Bei II-VI-Halbleitern bzw. handelt es sich in an sich bekannter Weise um Verbindungshalbleiter, die aus Elementen der Hauptgruppe II bzw. Gruppe-12-Elementen und Elementen der Hauptgruppe VI bestehen.

Viele Materialien zeichnen sich sowohl dadurch aus, dass sich ihr Brechungsindex in Abhängigkeit einer Spannung und/oder dem Vorhandensein von Ladung und/oder einem elektrischen Feld ändert, als auch dadurch, dass sie elektromagnetische Strahlung wenigstens einer Wellenlänge absorbieren und infolge der Absorption ein elektrisches Photosignal erzeugen. Für Graphen beispielsweise ist dies der Fall. Graphen ist entsprechend sowohl für die aktiven Elemente von Photodetektoren als auch Modulatoren geeignet. Dies gilt ebenfalls für Dichalkogenide, etwa zweidimensionale Übergangsmetall-Dichalkogenide, Heterostrukturen aus zweidimensionalen Materialien, Germanium, Silizium sowie Verbindungshalbleiter, insbesondere III-V-Halbleiter und/oder II-VI-Halbleiter. Lithiumniobad beispielsweise ist in der Regel nur für Modulatoren geeignet. Da es transparent ist, erfüllt es nicht die absorbierende Eigenschaft und kommt daher für Photodetektoren nicht in Frage.

Bei einem Material, das elektromagnetische Strahlung wenigstens einer Wellenlänge absorbiert und infolge der Absorption ein elektrisches Photosignal erzeugt und/oder dessen Brechungsindex sich in Abhängigkeit einer Spannung und/oder dem Vorhandensein von Ladung und/oder einem elektrischen Feld ändert kann man auch von einem elektro-optisch aktiven Material sprechen. Das aktive Element bzw. die aktiven Elemente umfassen mit anderen Worten wenigstens ein elektro-optisch aktives Material bzw. bestehen mit anderen Worten aus wenigstens einem elektro-optisch aktiven Material.

Es kann sein, dass das oder wenigstens eines der aktiven Elemente in Form eines Films vorliegt bzw. vorgesehen wird. Ein Film zeichnet sich bevorzugt in an sich bekannter Weise durch eine deutlich größere laterale Ausdehnung als Dicke aus. Das wenigstens ein aktives Element kann sich ferner durch einen quadratischen oder rechteckigen Querschnitt auszeichnen.

Das oder wenigstens ein aktives Element kann ferner eine oder mehrere Lagen bzw. Schichten aus wenigstens einem Material, dessen Brechungsindex sich ändert und/oder das absorbiert, umfassen oder aus einer oder mehreren Lagen bzw. Schichten wenigstens eines solchen gebildet sein. Insbesondere kann vorgesehen sein, dass das oder wenigstens ein aktives Element als Film ausgebildet ist, der mehrere Lagen bzw. Schichten aus einem oder auch verschiedenen Materialien umfasst.

Als besonders geeignet haben sich Filme aus Graphen, ggf. chemisch modifiziertem Graphen, oder auch Dichalkogenid-Graphen-Heterostrukturen bestehend aus mindestens einer Lage Graphen und mindestens einer Lage eines Dichalkogenids oder Anordnungen aus mindestens einer Lage Bornitrid und mindestens einer Lage Graphen erwiesen.

Aktive Elemente können beispielsweise auch eine oder mehrere Siliziumschichten umfassen bzw. dadurch gegeben sein. Insbesondere in diesem Fall kann vorgesehen sein, das eines oder mehrere aktive Elemente bzw. Abschnitte dieser einen Wellenleiter(abschnitt) bilden.

Das oder die aktiven Elemente können ferner dotiert sein bzw. dotierte Abschnitte bzw. Regionen aufweisen, beispielsweise p-dotiert und/oder n-dotiert sein bzw. entsprechende Abschnitte bzw. Regionen umfassen. Es kann auch sein, dass ein p- und ein n-dotierte Bereich und ein bevorzugt dazwischenliegender undotierter Bereich vorliegen bzw. vorgesehen werden. Dies wird auch als pin-Übergang bezeichnet, wobei das i für intrinsisch, also undotiert steht.

Im Rahmen der Herstellung des oder des jeweiligen aktiven Elementes können die gleichen Verfahren zum Einsatz kommen oder gekommen sein, die vorstehend im Zusammenhang mit den Gateelektroden erläutert wurden.

Diese schließen auch Transferverfahren ein. Dies bedeutet dann insbesondere, dass das bzw. das jeweilige Element nicht monolithisch etwa auf einer Schicht hergestellt wird/werden bzw. wurde/wurden, sondern separat hergestellt und dann transferiert, mit anderen Worten übertragen wird/werden bzw. wurde/wurden. Ein Transferverfahren für Graphen ist beispielsweise aus den Aufsätzen "Large-Area Synthesis of High-Quality and Uniform Graphene Films on Copper Foils" von Li et al., Science 324, 1312, (2009) und " Roll-to-roll production of 30-inch graphene films for transparent electrodes" von Bae et al, Nature Nanotech 5, 574-578 (2010) bzw. für LiNbO aus dem Aufsatz "Integrated lithium niobate electro-optic modulators operating at CMOS-compatible voltages", Nature volume 562, pages 101104 (2018) bzw. U.a. für GaAs aus dem Aufsatz "Transfer print techniques for heterogeneous integration of photonic components", Progress in Quantum Electronics Volume 52, March 2017, Pages 1-17 bekannt. Eines dieser Verfahren kann auch im Rahmen der vorliegenden Erfindung angewendet werden, um eine oder mehrere Graphen- bzw. LiNbO- bzw. GaAs-Schichten/-Filme zu erhalten. An ein Transferverfahren kann sich eine Strukturierung anschließen.

Oberhalb, ggf. auf wenigstens einem der aktiven Elemente kann ferner eine Passivierungsschicht und/oder ein Cladding vorgesehen sein. Ein Cladding ist insbesondere dazu geeignet bzw. ausgebildet, den Indexkontrast etwas geringer zu machen, so dass sich Rauheiten an den Seitenwänden nicht ganz so stark auswirken; üblicherweise gehen die Verluste in den bzw. die Wellenleiter zurück. Eine Passivierungsschicht dient bevorzugt dem Zweck, die Anordnung bzw. Schaltung vor Umwelteinflüssen, insbesondere Wasser, zu schützen. Eine Passivierungsschicht kann beispielsweise aus einem dielektrischen Material bestehen. Als besonders geeignet haben sich Aluminiumoxid (AL₂O₃) und Siliziumdioxid (SiO₂) erwiesen.

Eine obere, abschließende Passivierungsschicht weist zweckmäßiger Weise Öffnungen bzw. Unterbrechungen zu darunterliegenden Kontakten auf, um einen elektrischen Anschluss zu ermöglichen. Öffnungen bzw. Unterbrechungen in einer Passivierungsschicht können beispielsweise durch Lithographie und/oder Ätzen, insbesondere reaktives Ionenätzen, erhalten werden bzw. worden sein.

Das bzw. das jeweilige aktive Element kann an einer Seite oder auch jeweils an gegenüberliegenden Seiten mit einem Kontakt bzw. Kontaktelement verbunden sein. Die Kontakte bzw. Kontaktelemente können mit Verbindungselemente, insbesondere VIAs, in Kontakt stehen. Über die Verbindungselemente kann beispielsweise ein Anschluss an eines oder mehrere integrierte elektronische Bauteile aus dem Front-End-of-Line eines Chips oder Wafers erzielt werden. Unter verbunden sein ist zweckmäßiger Weise elektrisch leitfähig verbunden zu verstehen.

Es sei angemerkt, dass insbesondere im Falle eines Detektors mit nur einem aktiven Element vorgesehen sein kann, dass dieses mit zwei Kontakten bzw. Kontaktelementen in Kontakt steht, bevorzugt an gegenüberliegenden Seiten, und im Falle eines Modulators mit zwei aktiven Elementen bzw. einem aktiven Element und einer Elektrode gilt, dass diese jeweils mit einem Kontakt bzw. Kontaktelement in Kontakt stehen. Dies bevorzugt an denjenigen Endbereichen bzw. Enden, die von dem Bereich abgewandt sind, indem sie abschnittsweise übereinanderliegen bzw. überlappen.

Das oder wenigstens eines der aktiven Elemente ist bzw. wird zweckmäßiger Weise derart relativ zu dem Längsabschnitt des Wellenleiters angeordnet, dass es zumindest abschnittsweise dem evaneszenten Feld von elektromagnetischer Strahlung, diesem geführt wird, ausgesetzt ist. Bevorzugt ist oder wird wenigstens ein aktives Element in einem Abstand kleiner gleich 50 nm, besonders bevorzugt kleiner gleich 30 nm zu dem Längsabschnitt des Wellenleiters angeordnet, beispielsweise in einem Abstand von 10 nm.

Das oder wenigstens eines der aktiven Element zeichnet sich weiterhin bevorzugt durch eine Ausdehnung in Längsrichtung im Bereich von 5 bis 500 Mikrometern aus.

Es kann auch sein, dass sich das oder wenigstens eines der aktiven Elemente zumindest abschnittsweise auf dem und/oder innerhalb des Längsabschnitts des Wellenleiters erstreckt, im letztgenannten Falle beispielsweise zwischen zwei Segmenten dieses.

In weiterer vorteilhafter Ausgestaltung ist vorgesehen, dass das oder wenigstens eines der aktiven Elemente in einem im Querschnitt betrachtet zumindest im Wesentlichen Trapez-förmigen Bereich des Längsabschnitts des Wellenleiters auf oder oberhalb des Wellenleiters angeordnet ist und bevorzugt der Trapezform folgt. Alternativ oder zusätzlich kann vorgesehen sein, dass das oder wenigstens eines der aktiven Elemente in einem im Querschnitt betrachtet zumindest im Wesentlichen Trapez-förmigen Bereich einer Planarisierungsschicht auf oder oberhalb der Planarisierungsschicht angeordnet ist und bevorzugt der Trapezform folgt.

Bei Wellenleitern gilt, dass ein Teil der elektromagnetischen Strahlung, insbesondere des Lichts, evaneszent außerhalb des Wellenleiters geführt wird. Die Grenzfläche des Wellenleiters ist dielektrisch und entsprechend wird die Intensitätsverteilung durch die Randbedingungen gemäß Maxwell mit einem exponentiellen Abfall beschrieben. Wird ein elektro-optisch aktives Material, beispielsweise Graphen auf den bzw. in die Nähe des Wellenleiters in das evaneszente Feld gebracht, können Photonen mit dem Material, insbesondere Graphen, in Wechselwirkung treten.

Es existieren vier Effekte in Graphen, die zu einem Photosignal führen. Einerseits der bolometrischer Effekt, gemäß dem durch die absorbierte Energie der Widerstand des Graphens steigt und sich ein angelegter DC Strom reduziert. Die Änderung des DC Stroms ist dann das Photosignal. Ein weiterer Effekt ist die Photoleitfähigkeit. Dabei führen absorbierte Photonen zu einer Erhöhung der Ladungsträgerkonzentration und die zusätzlichen Ladungsträger reduzieren den Widerstand des Graphens wegen der Proportionalität des Widerstands zur Ladungsträgerkonzentration. Ein angelegter DC Strom erhöht sich und die Änderung ist das Photosignal. Es existiert auch ein thermoelektrischer Effekt, gemäß dem sich durch einen pn Übergang und einen Temperaturgradienten an diesem Übergang wegen unterschiedlicher Seebeckkoeffizienten für das p und n Gebiet eine Thermospannung ergibt. Der Temperaturgradient entsteht durch die Energie des absorbierten optischen Signals. Diese Thermospannung ist dann das Signal. Der vierte Effekt ist dadurch gegeben, dass an einem pn Übergang die angeregten Elektron-Lochpaare getrennt werden. Der resultierende Photostrom ist das Signal.

Im Falle eines Modulators kann, wie vorstehend dargelegt, eine elektrische Steuerelektrode und ein dazu zweckmäßiger Weise isoliertes aktives Element mit oder aus wenigstens einem Material, dessen Brechungsindex sich in Abhängigkeit einer Spannung bzw. von Ladungen bzw. einem elektrischen Feld ändert, insbesondere aus Graphen vorgesehen sein bzw. auch die Elektrode aus einem entsprechenden Material, insbesondere Graphen, bestehen, so dass im Betrieb dann zwei aktive Elemente gemeinsam im evaneszenten Feld sind und die elektro-optische Funktion ausführen. Graphen beispielsweise kann durch eine Steuerspannung seine optischen Eigenschaften ändern. Im besonders vorteilhaften Fall einer Graphen-Dielektrikum-Graphen-Anordnung entsteht eine Kapazität und die beiden Filme Graphen beeinflussen sich gegenseitig. Durch eine Spannung wird die Kapazität bestehend aus den Graphen-Elektroden bildenden beiden aktiven Elementen geladen und die Elektronen besetzen Zustände im Graphen. Daraus ergibt sich eine Verschiebung der Fermi-Energie (Energie des letzten besetzten Zustands im Kristall) zu höheren Energien (oder wegen Symmetrie zu niedrigeren). Erreicht die Fermi-Energie die halbe Energie der Photonen, können diese nicht mehr absorbiert werden, weil die für den Absorptionsvorgang erforderlichen freien Zustände bei der richtigen Energie bereits besetzt sind. In diesem Zustand ist das Graphen folglich transparent, weil die Absorption verboten ist. Durch Wechsel der Spannung wird das Graphen zwischen absorbierend und transparent hin und her geschaltet. Ein kontinuierlich leuchtender Laserstahl wird in seiner Intensität moduliert und kann so zur Informationsübertragung eingesetzt werden. Ebenfalls ändert sich der Realteil des Brechungsindexes mit der Steuerspannung. Durch Wechsel der Spannung kann über den sich ändernden Brechungsindex die Phasenlage eines Lasers moduliert und so Phasenmodulation erreicht werden. Bevorzugt wird die Phasenmodulation in einem Bereich betrieben, in dem alle Zustände bis über der halben Photonenenergie besetzt sind, so dass das Graphen transparent ist und sich maßgeblich der Realteil des Brechungsindexes verschiebt und die Änderung der Absorption eine untergeordnete Rolle spielt.

Ebenfalls im Zusammenhang sowohl mit den Photodetektoren gemäß dem ersten und zweiten Aspekt als auch den Modulatoren gemäß dem dritten, vierten und fünften Aspekt der Erfindung kann ferner das Folgende gelten.

Unter einem Wellenleiter und einem Längsabschnitt eines solchen ist insbesondere ein Element bzw. eine Komponente zu verstehen, die eine elektromagnetische Welle, etwa Licht, leitet. Um die Welle zu leiten wird zweckmäßiger Weise ein von der Wellenlänge abhängiger Querschnitt eines optisch transparenten Materials, das sich von einem benachbarten Material, das ebenfalls für diese Wellenlänge transparent ist, durch einen Brechungsindexkontrast auszeichnet, vorgesehen. Ist der Brechungsindex des umgebenden Materials niedriger, wird das Licht im Bereich des höheren Brechungsindexes geführt. Für den besonderen Fall einer Schlitzmode sind zwei Bereiche hohen Brechungsindexes von einem bezüglich der Wellenlänge schmalen Bereich niedrigen Brechungsindexes getrennt und das Licht wird im Bereich des niedrigen Brechungsindexes geführt. Um niedrige Verluste durch Streuung zu erreichen, ist eine geringe Seitenwandrauheit vorteilhaft.

In der Regel wird bzw. werden - beispielsweise auf einem Chip oder einem Wafer - einer oder mehrere Wellenleiter vorgesehen sein. Teil eines erfindungsgemäßen Photodetektors bzw. Modulators wird in der Regel nur ein Längsabschnitt eines solchen sein, zweckmäßiger Weise ein Längsabschnitt, der sich unterhalb eines aktiven Elementes dieses erstreckt. Selbstverständlich ist aber auch nicht ausgeschlossen, dass ein Wellenleiter über seinen gesamte Längsausdehnung als Bestandteil eines erfindungsgemäßen Photodetektors bzw. Modulators erachtet wird. Mit anderen Worten kann ein solcher zusätzlich zu dem sich insbesondere unterhalb eines aktiven Elementes erstreckenden Längsabschnitt eines Wellenleiters auch den Rest dieses umfassen.

Was die Abmessungen von Wellenleitern angeht, kann beispielsweise das Folgende gelten. Die Dicke liegt bevorzugt im Bereich von 150 Nanometern bis 10 Mikrometer. Die Breite und Länge der Wellenleiter kann sich insbesondere im Bereich von 100 Nanometer und 10 Mikrometer bewegen.

Einer Wellenleiter kann beispielsweise als Streifenwellenleiter ausgebildet sein, der sich beispielsweise durch einen rechteckigen oder quadratischen Querschnitt auszeichnet, was dann auch für einen Längsabschnitt eines solchen gilt. Ein Wellenleiter kann alternativ oder zusätzlich auch als Rippenwellenleiter mit T-förmigem Querschnitt ausgebildet sein. Weiter alternativ oder zusätzlich ist es möglich, dass ein Wellenleiter durch einen Schlitzwellenleiter gegeben ist.

Ein Wellenleiter bzw. Längsabschnitt eines solchen kann im Querschnitt betrachtet mehrere Abschnitte bzw. Segmente umfassen und mehrteilig ausgebildet sein, etwa ein erstes, beispielsweise unteres oder linkes, und ein zweites, beispielsweise oberes oder rechtes Segment umfassen oder daraus bestehen. Es kann sein, dass eines oder mehrere Wellenleitersegmente sich durch einen rechteckigen oder quadratischen Querschnitt auszeichnen. Auch ist es möglich, dass eines oder mehrere Segmente eines Wellenleiters sich zumindest abschnittsweise durch einen sich verjüngenden Querschnitt und/oder zumindest abschnittsweise durch einen sich verbreiternden Querschnitt auszeichnen.

Weist ein Wellenleiter zwei oder mehr Segmente auf bzw. besteht daraus, können diese aneinander anliegen oder ineinander übergehen oder auch - etwa unter Bildung wenigstens eines Spaltes bzw. Schlitzes (englisch: slot) - zueinander beabstandet sein.

Der Längsabschnitt des Wellenleiters umfasst - sowohl im Falle der vorgenannten Photodetektoren gemäß dem ersten und zweiten Aspekt als auch der vorgenannten Modulatoren gemäß dem dritten, vierten und fünften Aspekt der Erfindung - in besonders zweckmäßiger Ausgestaltung wenigstens ein Material, das für elektromagnetische Strahlung einer Wellenlänge von 850 nm und/oder 1310 nm und/oder 1550 nm transparent ist oder besteht aus einem solchen. Besonders bevorzugt ist es für elektromagnetische Strahlung im Wellenlängenbereich von 800 nm bis 900 nm und/oder von 1260 nm bis 1360 nm (sogenanntes Original Band bzw. kurz O-Band) und/oder 1360 nm bis 1460 nm (sogenanntes Extend Band oder kurz E-Band) und/oder 1460 nm bis 1530 nm (sogenanntes Short Band oder kurz S-Band) und/oder von 1530 nm bis 1565 nm (sogenanntes Conventional Band bzw. kurz C-Band) und/oder 1565 nm bis 1625 nm (sogenanntes Long Band bzw. kurz L-Band) transparent. Diese Bänder sind aus dem Bereich der Nachrichtentechnik vorbekannt.

Als Materialien für den Längsabschnitt des Wellenleiters haben sich beispielsweise als besonders geeignet erwiesen: Titandioxid und/oder Aluminiumnitrid und/oder Tantalpentoxid und/oder Siliziumnitrid und/oder Aluminiumoxid und/oder Siliziumoxynitrid und/oder Lithiumniobat und/oder Silizium, insbesondere Polysilizium, und/oder Indiumphosphit und/oder Galliumarsenid und/oder Indiumgalliumarsenid und/oder Aluminiumgalliumarsenid und/oder wenigstens ein Dichalkogenid, insbesondere zweidimensionales Übergangsmetall-Dichalkogenid, und/oder Chalkogenidglas und/oder Heterostrukturen aus zweidimensionalen Materialien und/oder Harze bzw. Harz enthaltende Materialien, insbesondere SU8, und/oder Polymere bzw. Polymere enthaltende Materialien, insbesondere OrmoClad und/oder OrmoCore. Dabei kann der Längsabschnitt des Wellenleiters eines oder mehrere dieser Materialien umfassen oder auch aus einem dieser Materialien oder aus einer Kombination von zwei oder mehr dieser Materialien bestehen. Dies kann jeweils nur für eines oder mehrere, ggf. alle Wellenleitersegmente gelten.

Weist der Längsabschnitt des Wellenleiters mehrere Wellenleitersegmente auf, können diese alle das oder die gleichen Materialien umfassen bzw. aus dem oder den gleichen Materialien bestehen. Es ist aber natürlich auch möglich, dass sich zwei oder mehr Segmente bezüglich ihres Materials bzw. ihrer Materialien unterscheiden. Es kann zum Beispiel sein, dass wenigstens ein Wellenleitersegment sich durch einen Brechungsindex auszeichnet, der größer ist als der Brechungsindex wenigstens eines weiteren Wellenleitersegmentes. Beispielsweise können für den Fall, dass mehrere Wellenleitersegmente sandwich- bzw. stapelartig übereinander liegen die äußeren Segmente einen geringeren Brechungsindex aufweisen. Dann wird das Licht in der Mitte der Wellenleiteranordnung gebündelt. Rein Beispielhaft für zugehörige Materialien seinen ein oberes und unteres Segment aus Aluminiumoxid mit einem zwischen diesen befindlichen mittleren Segment aus Titanoxid genannt.

Auch für ein Wellenleitersegment, das zwischen zwei aktiven Elementen liegt, hat sich ein - im Vergleich zu verbleibenden Segmenten höherer Brechungsindex als vorteilhaft erwiesen, da das Licht dann im Bereich der aktiven Elemente gebündelt wird.

Unterschiedliche Materialien der Segmente eines Wellenleiter(abschnitt)s können auch aus dem Grunde vorteilhaft sein, dass sich diese durch verschiedene Ätzraten auszeichnen. Dies kann Vorteile im Rahmen der Herstellung bieten, etwa für erforderliche Strukturierungen.

Die Herstellung des Längsabschnitts des Wellenleiters kann einschließen bzw. eingeschlossen haben, dass ein Wellenleitermaterial aufgebracht, insbesondere abgeschieden bzw. aufgeschleudert oder transferiert wird oder wurde, und anschließend bevorzugt eine Strukturierung des aufgebrachten Wellenleitermaterials insbesondere mittels Lithografie und/oder reaktivem Ionenätzen (RIE) durchgeführt wird oder wurde. Es können beispielsweise die gleichen Abscheidungsverfahren zum Einsatz kommen, die vorstehend im Zusammenhang mit den Gateelektroden genannt wurden.

Der Wellenleiter bzw. Längsabschnitt dieses kann ein- oder mehrteilig ausgebildet sein. Er kann - insbesondere im Querschnitt betrachtet - aus mehreren Wellenleitersegmenten gebildet sein bzw. mehrere Wellenleitersegmente umfassen. Diese können sowohl voneinander beabstandet sein als auch direkt aneinander liegen und in Kontakt miteinander stehen, beispielsweise, weil ein Segment unmittelbar auf einem anderen Segment hergestellt wurde, etwa durch Aufbringung, beispielsweise Abscheidung von Material.

Der Längsabschnitt des Wellenleiters besteht weiter bevorzugt aus wenigstens einem Material, dessen Brechungsindex sich von dem Brechungsindex eines ihn umgebenden Materials unterscheidet bzw. er umfasst wenigstens ein solches.

Handelt es sich bei dem Wellenleiter bzw. Wellenleiterlängsabschnitt um einen solchen, der zwei oder mehr Segmente umfasst, von denen wenigstens zwei unter Bildung eines Spaltes voneinander beabstandet sind, kann in vorteilhafter Ausgestaltung vorgesehen sein, dass der Spalt mit wenigstens einem dielektrischen Material gefüllt ist bzw. wird, dessen Brechungsindex kleiner als der Brechungsindex des Materials der den Spalt definierenden Wellenleitersegmenten ist.

Den Längsabschnitt des Wellenleiters an einer oder mehreren Seiten umgeben kann beispielsweise eine Planarisierungsschicht. Als rein beispielhafte Paare von Brechungsindices in einem solchen Falle seien genannt 3,4 (Si) für den Wellenleiterlängsabschnitt und 1,5 (SiO2) für die Planarisierungsschicht oder, im Falle von Dielektrika, 2,4 (TiO2) für den Wellenleiterlängsabschnitt und 1,5 (SiO2) für die Planarisierungsschicht oder 2 (SiN) für den Wellenleiterlängsabschnitt und für die 1,47 Planarisierungsschicht.

Besonders bevorzugt gilt, dass der Brechungsindex des Längsabschnitts des Wellenleiters um mindestens 20 %, bevorzugt mindestens 30 % größer ist als der Brechungsindex des umgebenden Material.

Der Längsabschnitt des Wellenleiters kann ferner auf oder oberhalb einer Planarisierungsschicht angeordnet sein.

Bevorzugt zeichnet sich die Planarisierungsschicht dann an derjenigen Seite, an welcher der Längsabschnitt des Wellenleiters auf dieser angerordnet ist, zumindest abschnittsweise durch eine Rauheit im Bereich von 1,0 nm RMS bis 0,1 nm RMS, insbesondere 0,6 nm RMS bis 0,1 nm RMS, bevorzugt 0,4 nm RMS bis 0,1 nm RMS aus. Die Abkürzung nm steht hier und im Folgenden in an sich bekannter Weis für Nanometer (10-9 m).

Alternativ oder zusätzlich kann der Längsabschnitt des Wellenleiters zumindest abschnittsweise in eine Planarisierungsschicht eingebettet sein, und das aktive Element oder - im Falle des Modulators mit zwei solchen - eines der aktiven Elemente auf der Planarisierungsschicht angeordnet ist. Hier kann dann bevorzugt gelten, dass sich die Planarisierungsschicht an derjenigen Seite, an welcher das aktive Element auf dieser angerordnet ist zumindest abschnittsweise durch eine Rauheit im Bereich von 1,0 nm RMS bis 0,1 nm RMS, insbesondere 0,6 nm RMS bis 0,1 nm RMS, bevorzugt 0,4 nm RMS bis 0,1 nm RMS auszeichnet.

Ist der Längsabschnitt des Wellenleiters sowohl auf der Oberseite einer Planarisierungsschicht angeordnet als auch in eine Planarisierungsschicht eingebettet, sind zwei Planarisierungsschichten vorhanden.

Zum Erzielen geeigneter Rauheit kann beispielsweise ein chemisch-mechanisches Polieren und/oder eine Resist-Planarisierung durchgeführt werden oder worden sein.

Beim chemisch-mechanischen Polieren wird ein zu polierendes Objekt in der Regel durch eine rotierende Bewegung zwischen Schleifpads poliert. Die Politur erfolgt zum einen chemisch und zum anderen physikalisch mittels einer Schleifpaste. Durch die Kombination der chemischen und physikalischen Wirkung können auf sub-nm-Skala glatte Oberflächen erhalten werden.

Die Resistplanarisierung schließt insbesondere ein einmaliges oder wiederholtes Spin-on-Glass-Aufschleudern und anschließendes Ätzen, bevorzugt reaktives Ionenätzen (englisch: reactive ion etching, kurz: RIE), mit ein. Soll eine Oberfläche, etwa eine SiO₂-Oberfläche, die Höhenunterschiede aufweist, planarisiert werden, kann das mittels Spin-On-Glass aufschleudern und Ätzen erfolgen. Die Spin-on-Glass-Schicht gleicht teilweise die Höhenunterschiede aus, d.h. Täler der Topologie weisen nach der Spin-on-Glass-Beschichtung eine höhere Schichtdicke auf als benachbarte Erhöhungen. Die Ätzrate von Spin-on-Glass und beispielsweise SiO₂ ist in einem angepassten RIE-Prozess ähnlich oder gleich. Unter angepasst ist hier insbesondere zu verstehen, dass der Druck, der Gasfluss, die Zusammensetzung des Gasgemisches und die Leistung entsprechend gewählt werden. Wird nach der Spin-on-Glass-Beschichtung die gesamte Spin-on-Glass-Schicht per RIE geätzt, hat sich der Höhenunterschied wegen der planarisierenden Wirkung der Spin-on-Glass-Schicht reduziert. Durch Wiederholung kann der Höhenunterschied weiter reduziert werden. Die konsumierte SiO₂-Schichtdicke muss beim Aufbringen der SiO₂ Schicht berücksichtigt werden, so dass nach Abschluss des letzten Ätzschritts die gewünschte SiO₂ Schichtdicke erreicht wird. Es sei betont, dass die Resistplanarisierung nicht auf SiO₂ beschränkt ist, sondern auch für andere Materialien in Frage kommt. Zweckmäßig ist, wenn eine Ätzrate des Materials erzielt werden kann, die derjenigen von Spin-On-Glass ähnelt bzw. zumindest im Wesentlichen mit dieser übereinstimmt. Für SiO₂ und Spin-On-Glass ist diese Bedingung erfüllt. Es sei angemerkt, dass beispielsweise auch Materialien, deren Ätzrate von derjenigen von Spin-On-Glass um einen Faktor 2 abweicht, möglich sind, wobei dann in der Regel mehrere Durchgänge nötig sind. Als flüssiges Material aufgebracht, insbesondere aufgeschleudert werden kann beispielsweise Wasserstoff-Silsesquioxan und/oder ein Polymer. Dieses verglast bei einem anschließenden Ausheizen, weshalb es auch als Spin-on-Glas bezeichnet wird. Bei Wasserstoff-Silsesquioxan (englisch: hydrogen silsesquioxane, kurz: HSQ) handelt es sich um eine Klasse anorganischer Verbindungen mit der Formel [HSiO_{3/2}]ₙ.

Das chemisch-mechanische Polieren und/oder die Resistplanarisierung können insbesondere derart durchgeführt werden oder worden sein, dass eine Rauheit im Bereich von 1,0 nm RMS bis 0,1 nm RMS, insbesondere 0,6 nm RMS bis 0,1 nm RMS, bevorzugt 0,4 nm RMS bis 0,1 nm RMS erhalten wird oder wurde.

Rauheiten in den genannten Bereichen haben sich als besonders geeignet erwiesen. Sie sind insbesondere vorteilhaft, um Stress und Verspannungen in darüber liegenden Schichten zu vermeiden. In diesem Zusammenhang sei auch auf den Aufsatz " Identifying suitable substrates for high-quality graphene-based heterostructures" von L. Banszerus et al, 2D Mater., Vol. 4, No. 2, 025030, 2017 verwiesen.

Es sei angemerkt, dass für den Fall, dass sich die dielektrischen Schicht, die bei dem Photodetektor gemäß dem ersten Aspekt der Erfindung insbesondere zwischen den Gateelektroden und dem aktiven Element vorgesehen sein kann, an ihrer Oberseite durch eine Rauheit in dem vorgenannten Bereich auszeichnet, diese auf die gleiche Weise erzielt werden bzw. worden sein kann, also beispielsweise durch CMP und/oder Resistplanarisierung.

Als Messverfahren zur Bestimmung der Rauheit kann die Rasterkraftmikroskopie (englisch: atomic force microscopy, kurz: AFM) zum Einsatz kommen, insbesondere, wie in der Norm EN ISO 25178 beschrieben. Die Rasterkraftmikroskopie ist vor allem in dem sich mit Messmethoden zur Rauheitsbestimmung beschäftigten Teil 6 (EN ISO 25178-6:2010-01) dieser Norm erörtert.

Weiterhin kann vorgesehen sein, dass die Planarisierungsschicht und/oder eine ggf. vorhandene weitere Planarisierungsschicht eine oder mehrere Decklagen umfassen, die bevorzugt auf einer einer Planarisierungsbehandlung unterzogenen Oberfläche vorgesehen sind bzw. werden und bei denen es sich beispielsweise um Dichalkogenidlagen oder Dichalkogenid-Heterostrukturen oder auch Bornitridlagen handeln kann. Diese Materialen werden bevorzugt abgeschieden oder transferiert ohne das es eines weiteren chemisch-mechanischen Polierens bzw. weiteren Resistplanarisierens bedarf, wobei auch nicht ausgeschlossen ist, dass dies nochmals erfolgt.

Auch kann vorgesehen sein, dass die oder die jeweilige Planarisierungsschicht durch Abscheidung erhalten wird bzw. eine durch Abscheidung erhaltene Schicht ist. Prinzipiell können für die Planarisierungsschicht die gleichen Verfahren zur Anwendung kommen bzw. gekommen sein, die vorstehend im Zusammenhang mit den Gateelektroden genannt wurden (beispielsweise CVD, PVD, Atomlagenabscheidung, Transfer). Dies und das Folgende für die Planarisierungsschicht erläuterte kann auch für die gegebenenfalls vorhandene dielektrische Schicht gelten.

Eine Schicht kann nur genau eine oder auch mehrere Lagen umfassen. Sie kann aus nur einem Material bestehen oder auch mehrere Materialien umfassen. Beispielsweise kann eine Schicht zwei oder mehr Lagen aus zwei oder mehr verschiedenen Materialien aufweisen. Es kann natürlich auch sein, dass eine Schicht mehrere Lagen aufweist, die jedoch alle aus demselben Material bestehen. Eine Schicht mit mehr als einer Lage kann insbesondere erhalten werden bzw. vorliegen, weil für deren Herstellung mehrere Lagen, beispielsweise mehrere Atomlagen, vorgesehen, beispielsweise abgeschieden werden bzw. wurden.

Die oder die jeweilige Planarisierungsschicht kann weiterhin Spin-on-Glass und/oder wenigstens ein Polymer und/oder wenigstens ein Oxid, insbesondere Siliziumdioxid, und/oder wenigstens ein Nitrid umfassen oder daraus bestehen. Bei Spin-on-Glass handelt es sich in der Regel um einen flüssigen Stoff, mit dem Wafer durch aufschleudern beschichtet werden können. Nach dem Schleudern ergibt sich eine Schicht auf dem Wafer, deren Dicke von der Oberflächentopologie abhängt. Vertiefungen werden so zum Teil ausgeglichen und die Spin-on-Glass-Beschichtung hat eine planarisierende Wirkung. Spin-on-Glass wird in der Regel nach dem Aufbringen erhitzt und wird dadurch eine glasartige Schicht.

Insbesondere bei einem Modulator kann weiterhin vorgesehen sein, dass er eine Diode oder Kapazität umfasst. Es kann sich beispielsweise um einen integrierten III-V Halbleiter Modulator handeln, wie er in dem Aufsatz " Heterogeneously integrated III- V/Si MOS capacitor Mach- Zehnder modulator" von Hiaki, Nature Photonics volume 11, pages 482- 485 (2017) beschrieben ist.

Ist bzw. wird eine Diode vorgesehen, kann diese beispielsweise eine Mehrzahl von Schichten unterschiedlicher Zusammensetzung von beispielsweise InGaAsP umfassen, insbesondere, um einen pn-Übergang und zwei Kontaktgebiete zu erzeugen.

Gegenstand der Erfindung ist auch eine Halbleitereinrichtung umfassend einen Chip und wenigstens einen, bevorzugt mehrere Photodetektoren und/oder Modulatoren gemäß der vorliegenden Erfindung, wobei der oder die Photodetektoren und/oder Modulatoren bevorzugt auf dem Chip oder auf einer auf dem Chip oder oberhalb des Chips angeordneten Schicht angeordnet sind.

Schließlich betrifft die Erfindung eine Halbleitervorrichtung umfassend einen Wafer und wenigstens einen, bevorzugt mehrere Photodetektoren und/oder Modulatoren gemäß der vorliegenden Erfindung, wobei der oder die Photodetektoren und/oder Modulatoren bevorzugt auf dem Wafer oder auf einer auf dem Wafer oder oberhalb des Wafers angeordneten Schicht angeordnet sind.

Der bzw. die Photodetektoren und/oder Modulatoren können beispielsweise Bestandteil einer auf dem Chip oder Wafer hergestellten oder mit dem Chip oder Wafer gebondeten photonischen Plattform sein.

Unter gebondet ist dabei insbesondere zu verstehen, dass der bzw. die Photodetektoren und/oder Modulatoren nicht auf oder oberhalb des Chips bzw. Wafers sondern separat von diesem hergestellt werden bzw. wurden und nach ihrer Herstellung - ggf. auch Als Bestandteil einer größeren Einheit - mit dem Chip bzw. Wafer verbunden werden bzw. wurden, etwa unter Verwendung einer geeigneten Zwischenschicht.

Wird ein Chip oder Wafer im Querschnitt betrachtet, lässt sich sein vertikaler Aufbau in unterschiedliche Teilbereiche einteilen. Der unterste Teil ist das Front-End-of-Line oder kurz FEOL, das in der Regel eines oder mehrere integrierte elektronische Bauteile umfasst. Bei dem bzw. den integrieren elektronischen Bauteilen kann es sich beispielsweise um Transistoren und/oder Kondensatoren und/oder Widerstände handeln. Über dem Front-End-of-Line befindet sich das Back-End-of-Line oder kurz BEOL, in dem in der Regel verschiedene Metallebenen liegen, mittels derer die integrierten elektronischen Bauteile des FEOL verschaltet werden.

Ein Wafer umfasst eine Mehrzahl von Bereichen, die im Anschluss an das Dicen/Zerkleinern/Vereinzeln jeweils einen Chip bzw. Die bilden. Diese Bereiche werden vorliegend auch als Chip- bzw. Die-Bereiche bezeichnet. Jeder Chipbereich des Wafers umfasst bevorzugt einen Abschnitt bzw. Teilbereich des insbesondere einteiligen Halbleitersubstrats des Wafers. Bevorzugt weist ferner jeder Chipbereich einen oder mehrere integrierte elektronische Bauteile auf, die sich in und/oder auf dem entsprechenden Bereich des Halbleitersubstrats - im Querschnitt betrachtet insbesondere im FEOL - erstrecken. Es sei betont, dass die Chipbereiche keine vereinzelten Chips darstellen, der Wafer also keine vereinzelten Chips umfasst.

Sowohl für eine erfindungsgemäße Halbleitereinrichtung als auch für eine erfindungsgemäße Halbelitervorrichtung kann gelten, dass diese mehrere baugleiche erfindungsgemäße Photodetektoren und/oder mehrere baugleiche erfindungsgemäße Modulatoren umfasst oder auch mehrere verschieden gestaltete erfindungsgemäße Photodetektoren und/oder mehrere verschieden gestaltete erfindungsgemäße Modulatoren. Es können auch einige gleiche und zusätzlich einer oder mehrere davon verschiedene Photodetektoren und/oder Modulatoren vorhanden sein.

Hinsichtlich der Ausgestaltungen der Erfindung wird auch auf die Unteransprüche sowie auf die nachfolgende Beschreibung mehrerer Ausführungsbeispiele unter Bezugnahme auf die beiliegende Zeichnung verwiesen.

In der Zeichnung zeigt:
- Figur 1: einen Teilschnitt durch eine Halbleitervorrichtung mit einem Ausführungsbeispiel eines Photodetektors gemäß dem ersten Aspekt der Erfindung;
- Figur 2: eine Aufsicht auf den Photodetektor aus Figur 1;
- Figur 3: einen Teilschnitt durch eine Halbleitervorrichtung mit einem weiteren Ausführungsbeispiel eines Photodetektors gemäß dem ersten Aspekt der Erfindung;
- Figur 4: einen Teilschnitt durch eine Halbleitervorrichtung mit einem Ausführungsbeispiel eines Photodetektors gemäß dem zweiten Aspekt der Erfindung;
- Figur 5: einen Teilschnitt durch eine Halbleitervorrichtung mit einem Ausführungsbeispiel eines elektro-optischen Modulators gemäß dem dritten Aspekt der Erfindung;
- Figur 6: einen Teilschnitt durch eine Halbleitervorrichtung mit einem Ausführungsbeispiel eines elektro-optischen Modulators gemäß dem vierten Aspekt der Erfindung;
- Figur 7: einen Teilschnitt durch eine Halbleitervorrichtung mit einem Ausführungsbeispiel eines elektro-optischen Modulators gemäß dem fünften Aspekt der Erfindung; und
- Figur 8: die Schritte des Verfahrens zur Herstellung der Vorrichtung gemäß Figur 1.

Alle Figuren zeigen rein schematische Darstellungen. In den Figuren sind gleiche Komponenten bzw. Elemente mit gleichen Bezugszeichen versehen.

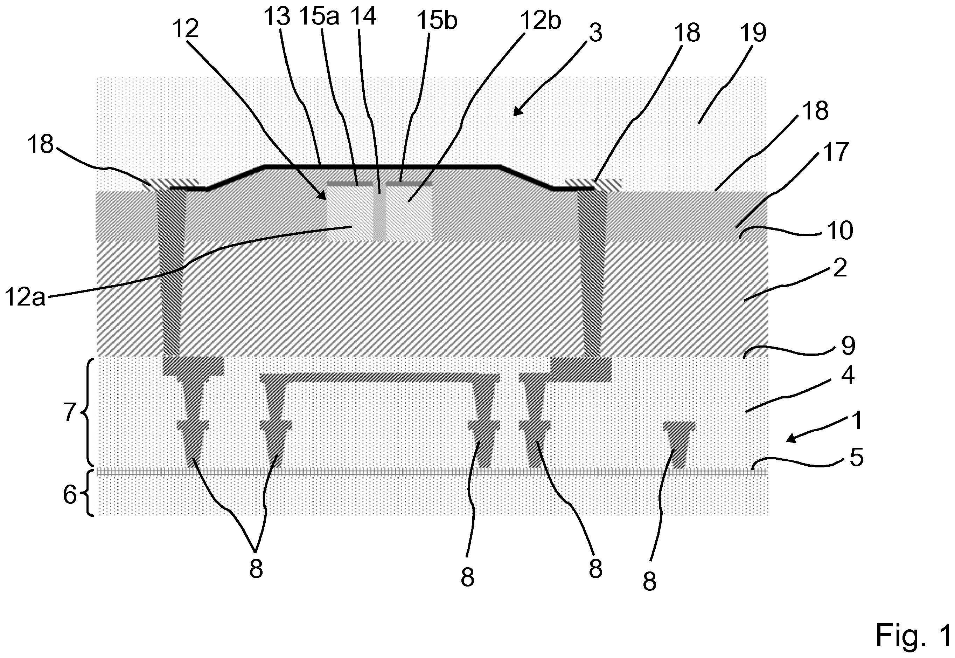

Die Figur 1 zeigt einen Teilschnitt durch ein Ausführungsbeispiel einer erfindungsgemäßen Halbleitervorrichtung.

Diese umfasst einen Wafer 1, eine auf dem Wafer 1 hergestellte Planarisierungsschicht 2 und eine Mehrzahl von auf den Planarisierungsschicht 2 hergestellten Photodetektoren 3. In dem Teilschnitt gemäß Figur 1 ist dabei nur einer der Photodetektoren 3 beispielhaft gezeigt.

Der Wafer 1 umfasst vorliegend einteiliges Siliziumsubstrat 4 und eine Mehrzahl von integrierten elektronischen Bauteilen 5, die sich bei dem gezeigten Beispiel in dem Halbleitersubstrat 4 erstreckten. Die integrierten elektronischen Bauteile 5, bei denen es sich insbesondere um Transistoren und/oder Widerstände und/oder Kondensatoren handeln kann, sind in der schematischen Figur 1 nur vereinfacht durch eine mit dem Bezugszeichen 5 versehene Linie mit Schraffur angedeutet. An entsprechender Stelle in dem Substrat 4 findet sich in hinlänglich vorbekannter Weise eine Vielzahl integrierter elektronischer Bauteile 5. Diese können in ebenfalls vorbekannter Weise Bestandteile von Prozessoren, etwa CPUs und/oder GPUs sein bzw. solche bilden.

Der Wafer 1 hat ein Front-End-of-Line (kurz FEOL) 6, in dem die Mehrzahl integrierter elektronischer Bauteile 5 angeordnet ist und ein darüber liegendes Back-End-of-Line (kurz BEOL) 7, in dem bzw. über das die integrierten elektronischen Bauteile 5 des Front-End-of-Lines 6 mittels verschiedener Metallebenen verschaltet sind. Die integrierten elektronischen Bauteile 5 im FEOL 6 und die zugehörige Verschaltung im BEOL 7 bilden in hinlänglich vorbekannter Weise integrierte Schaltkreise des Wafers 1. Ein FEOL 6 wird teilweise auch als Transistor-Frontend und ein BEOL 7 als Metall-Backend bezeichnet. Die Metallebenen umfassen eine Mehrzahl von Verbindungselementen 8, die vorliegend durch sogenannte VIAs gegeben sind, was die Abkürzung für Vertical Interconnect Access ist. Die VIAs 8 bestehen aus Metall, beispielswiese Kupfer, Aluminium oder Wolfram.

Die Planarisierungsschicht 2 ist auf der von dem Front-End-of-Line 6 abgewandten Oberseite 9 des Wafers 1 hergestellt und besteht aus einem dielektrischen Material ist. Vorliegend besteht die Planarisierungsschicht 2 aus Siliziumdioxid (SiO₂), wobei dies beispielhaft zu verstehen ist und auch andere Materialien zum Einsatz kommen können.

Die Planarisierungsschicht 2 ist bei dem dargestellten Ausführungsbeispiel eine durch Abscheidung des entsprechenden Beschichtungsmaterials, hier SiO₂, auf der vom Front-End-of-Line 6 abgewandten Oberseite 9 des Wafers 1 und anschließende Planarisierungsbearbeitung des abgeschiedenen Materials auf der von dem Wafer 1 abgewandten Oberseite 10 erhaltene Schicht. Die Planarisierungsschicht 2 zeichnet sich aufgrund der Bearbeitung an ihrer von dem Wafer 1 abgewandten Oberseite 10 vorliegend durch eine Rauheit von 0,2 nm RMS aus, wobei dies beispielhaft zu verstehen ist.

Die Planarisierungsschicht 2 erstreckt sich bei dem dargestellten Beispiel über die gesamte Oberseite 9 des Wafers 1. Das Material der Planarisierungsschicht 2 wurde vollflächig auf der gesamten Oberseite 9 des Wafers 1 abgeschieden. Diese zeichnet sich durch daher einen Durchmesser aus, der zumindest im Wesentlichen mit demjenigen des Wafers 1 übereinstimmt.

Die auf der Planarisierungsschicht 2 hergestellten Photodetektoren 3 sind Ausführungsbeispiele eines erfindungsgemäßen Photodetektors 3 gemäß dem ersten Aspekt der Erfindung. Bei dem Ausführungsbeispiel sind diese alle baugleich, wobei dies nicht einschränkend zu verstehen ist.

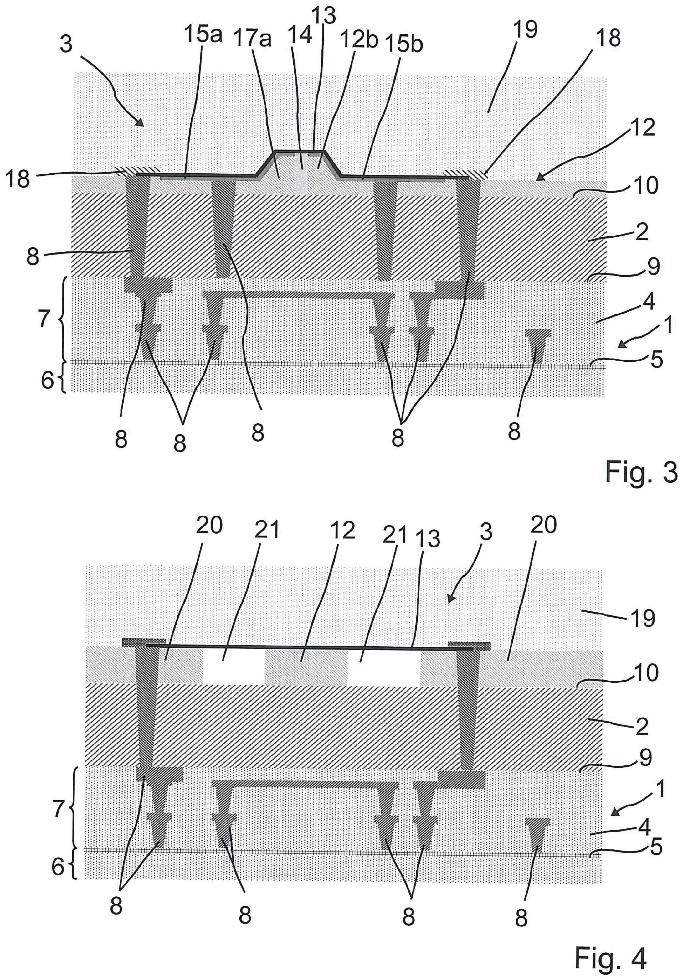

Im Folgenden wird der Aufbau der Detektoren 3 und auch deren Herstellung beispielhaft anhand des eine in Figur 1 dargestellten Detektors 3 beschrieben. Auch bezüglich der weiter unten beschriebenen Beispiele weiterer Detektoren und Modulatoren (vgl. die Figuren 3 bis 6) gilt, dass der Aufbau und jeweils anhand des einen in den Teilschnitten erkennbaren Beispiels erläutert wird.

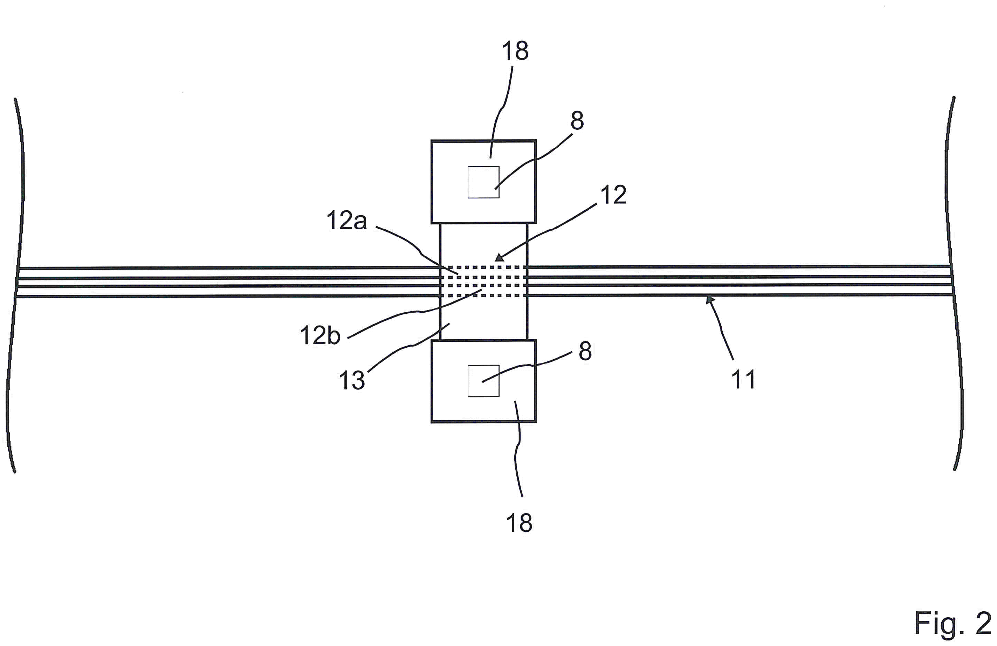

Der (jeweilige) Photodetektor 3 umfasst einen Längsabschnitt 12 eines der Wellenleiters 11, konkret denjenigen Längsabschnitt, den ein aktives Element 13 des Photodetektors 3 übergreift. In der Figur 2, welche in rein schematischer Aufsicht das aktive Element 13 und den darunterliegenden Wellenleiter 11 zeigt, ist der hier vom aktiven Element 13 verdeckte Längsabschnitt 12 des Wellenleiters mit gestrichelten Linien dargestellt.

Als Wellenleitermaterialien kommen insbesondere Dielektrika, vorzugsweise Titandioxid in Frage, welches auch bei dem dargestellten Ausführungsbeispiel verwendet wurde. Alternativ oder zusätzlich können auch einer oder mehrere Wellenleiter 11 aus Aluminiumnitrid und/oder Tantalpentoxid und/oder Siliziumnitrid und/oder Aluminiumoxid und/oder Siliziumoxinitrid und/oder Lithiumniobat oder auch aus Halbleitern wie Silizium, Indiumphosphid, Galliumarsenid, Indiumgalliumarsenid, Aluminiumgalliumarsenid oder Dichalkogenide oder Chalkogenidglas oder Polymere wie SU8 oder OrmoClad und/oder OrmoCore vorgesehen sein.

Der Längsabschnitt 12 des Wellenleiters 11 ist hier durch zwei sich in Längsrichtung und zumindest im Wesentlichen parallel zueinander erstreckende Wellenleitersegmente 12a, 12b, die in Querrichtung (in der Figur von links nach rechts bzw. umgekehrt) unter Bildung eines sich zwischen ihnen erstreckenden Spaltes 14 voneinander beabstandet sind, gebildet. Es handelt sich somit um einen Schlitzwellenleiter. Mittels eines solchen Wellenleiters 11 wird im Betrieb die optische Mode im Spalt 14 geführt. Die beiden Wellenleitersegmente zeichnen sich bei dem dargestellten Beispiel durch einen rechteckigen Querschnitt aus. Der Spalt 14 kann beispielsweise mit SiO₂ gefüllt sein.

Die beiden Wellenleitersegmente 12a, 12b stehen jeweils an wenigstens einer Seite, vorliegend an ihrer dem aktiven Element 13 zugewandten Seite mit einer aus Silizium bestehenden Gateelektrode 15a, 15b in Kontakt. Die beiden Gateelektroden 15a, 15b werden vorliegend durch eine auf dem jeweiligen Wellenleitersegment 12a, 12b hergestellte Siliziumschicht bzw. Siliziumbeschichtung gebildet.

Das aktive Element 13 umfasst wenigsten ein Material oder besteht aus wenigstens einem Material, das elektromagnetische Strahlung wenigstens einer Wellenlänge absorbiert und infolge der Absorption ein elektrisches Photosignal erzeugt. Bei dem gezeigten Beispiel ist es durch einen Graphenfilm 13 gegeben. Graphen kann auch seinen Brechungsindex (Brechzahl und/oder Absorption) in Abhängigkeit einer Spannung und/oder von Ladung und/oder einem elektrischen Feld ändern. Es sei betont, dass es auch möglich ist, dass das aktive Elemente 13 durch einen Film mit oder aus wenigstens einem anderen bzw. weiteren elektro-optisch aktiven Material gegeben ist, beispielsweise einen Film mit oder aus einer Dichalkogenid-Graphen-Heterostruktur bestehend aus mindestens einer Lage Graphen und mindestens einer Lage eines Dichalkogenids, oder durch einen Film, der mindestens eine Lage Bornitrid und mindestens eine Lage Graphen umfasst.

Wie man der Figur 1 entnehmen kann, ist der Graphenfilm 13 auf der von dem Wafer 1 abgewandten Oberseite 16 einer weiteren Planarisierungsschicht 17, in welche der Wellenleiter 11 und somit dessen Längsabschnitt 12 eingebettet ist, angeordnet. Die weitere Planarisierungsschicht 17 besteht aus dem gleichen Material wie die Planarisierungsschicht 2 und zeichnet sich an ihrer Oberseite 16 durch die gleiche Rauheit aus, wie die Oberseite 10 der Schicht 2. Dies ist jedoch nur beispielhaft und nicht einschränkend zu verstehen.

Mittels der auf den Wellenleitersegmenten 12a, 12b vorgesehenen Gateelektroden 15a, 15b kann in dem Graphenfilm 13 ein pn-Übergang in dem sich oberhalb des Spaltes 14 und somit im Bereich einer im Betrieb in dem Spalt 14 des Wellenleiters 11 geführten optischen Mode realisiert werden. Ein pn-Übergang kann dazu genutzt werden, durch Absorption erzeugte Elektron-Loch-Paare zu separieren und so einen Photostrom zu erzeugen. Ebenfalls kann in Graphen der thermoelektrische Effekt ausgenutzt werden, wobei in den p- und n-Gebieten Seebeckkoeffizienten mit gegensätzlichem Vorzeichen entstehen, die bei Erwärmung durch die absorbierte Energie (die Photonen) eine Thermospannung ergeben.

Es sei angemerkt, dass der nicht weiter dargestellte Anschluss der Gateelektroden 15a, 15b zur Spannungsversorgung beispielsweise seitlich neben den VIAs 8 liegen kann.

Der Photodetektor 3, konkret dessen Graphenfilm 13 ist mit wenigstens einem der integrierten elektronischen Bauteile 5 des Front-End-of-Lines 6 des Wafers 1 elektrisch leitend verbunden. Wie man in der schematischen Schnittdarstellungen gemäß den Figur 1 erkennen kann, ist die Verbindung über die VIAs 8 des Back-End-of-Lines 7 des Wafers 1 sowie weitere VIAs 8, die sich durch die Planarisierungsschicht 2 und darauf ggf. vorhandene weitere Schichten bzw. Elemente, vorliegend die weitere Planarisierungsschicht 17 erstrecken, realisiert.

Konkret ist Graphenfilm 13 an gegenüberliegenden Endbereichen über Kontakte bzw. Kontaktelemente 18 mit dem oberen Ende von VIAs 8, die sich durch weitere Planarisierungsschicht 17 und die Planarisierungsschicht 2 bis zum Back-End-of-Line 7 des Wafers 1 erstecken, elektrisch leitfähig verbunden. In der Aufsicht aus Figur 2 sind die mit den Kontaktelementen 18 in Verbindung stehenden VIAs 8, welche unterhalb Ersterer liegen, mit dünner Linie angedeutet.

Auf den Graphenfilmen 13 ist bei dem gezeigten Beispiel noch eine Passivierungsschicht 19 vorgesehen, die Aluminiumoxid (AL₂O₃) und/oder Siliziumdioxid (SiO₂) umfasst bzw. daraus besteht.

Ein Photodetektor 3, wie er in Figur 1 und den im Folgenden noch erläuterten Figuren 3 und 4 gezeigt ist, kann in an sich bekannter Weise insbesondere der Signalwandlung zurück von der optischen in die elektronische Welt dienen.

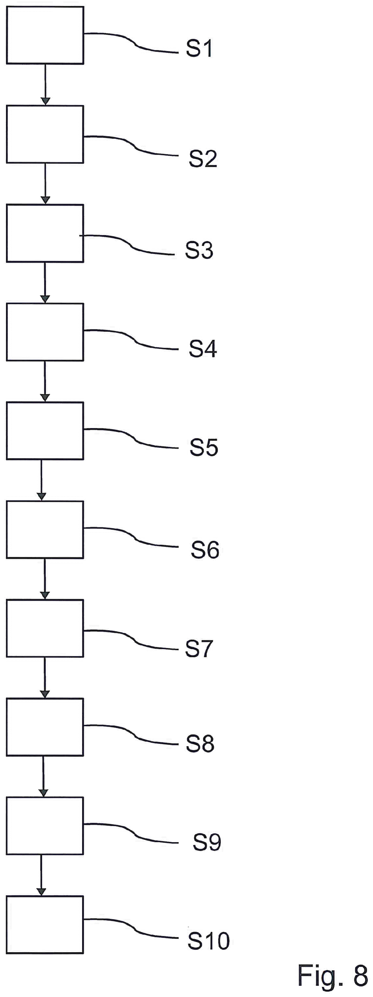

Zum Erhalt der in Figur 1 dargestellten Halbleitervorrichtung wird in einem ersten Schritt S1 (vgl. Figur 8) der Wafer 1 mit den die integrierten elektronischen Bauteilen 5 und die Metallisierung einschließlich der VIAs 8 umfassenden integrierten Schaltungen bereitgestellt. Bei dem Wafer 1 kann es sich um einen beliebigen Wafer 1 konventioneller Art handeln, der durch ein vorbekanntes Herstellungsverfahren erhalten wurde.

In einem zweiten Schritt S2 wird die Planarisierungsschicht 2 auf dem Back-End-of-Line 7 des Wafers 1 hergestellt. Hierfür wird ein Beschichtungsmaterial, vorliegend Siliziumdioxid (SiO₂), aufgebracht, was beispielsweise durch chemische Gasphasenabscheidung, etwa Niederdruck chemische Gasphasenabscheidung oder plasmaunterstütze chemische Gasphasenabscheidung, oder physikalische Gasphasenabscheidung oder auch durch Aufschleudern von Spin-on-Glas erfolgen kann. Vorliegend kommt PECVD zum Einsatz. Nachdem das Beschichtungsmaterial deponiert wurde, wird die Oberseite der erhaltenen Beschichtung einer Planarisierungsbehandlung unterzogen (Schritt S3), vorliegend einer Resistplanarisierung, wodurch eine Oberseite 10 mit einer Rauheit von 0,2 nm RMS erhalten wird.

Die Resistplanarisierung schließt dabei ein einmaliges oder wiederholtes Spin-on-Glass-Aufschleudern und anschließendes Ätzen, vorliegend reaktives Ionenätzen (RIE), ein. Die Spin-on-Glass-Schicht gleicht teilweise die Höhenunterschiede aus, d.h. Täler der Topologie weisen nach der Spin-on-Glass-Beschichtung eine höhere Schichtdicke auf als benachbarte Erhöhungen. Wird nach der Spin-on-Glass-Beschichtung die gesamte Spin-on-Glass-Schicht, etwa per RIE geätzt, hat sich der Höhenunterschied wegen der planarisierenden Wirkung der Spin-on-Glass-Schicht reduziert. Durch Wiederholung kann der Höhenunterschied weiter reduziert werden, bis die gewünschte Rauheit erhalten ist. Es sei angemerkt, dass eine Oberseite 10 der Planarisierungsschicht 2 entsprechend geringer Rauheit alternativ beispielsweise auch über chemisch-mechanisches Polieren (CMP) erhalten werden kann.

In einem nächsten Schritt S4, welcher vorliegend den ersten Schritt der Herstellung des Detektors 3 darstellt, wird der (jeweilige) Wellenleiter 11 mit den Gateelektroden 15a, 15b hergestellt. Hierfür wird Wellenleitermaterial, vorliegend Titandioxid (TiO₂), abgeschieden, dies insbesondere flächig über die gesamte Oberseite 10 der erhaltenen Planarisierungsschicht 2. Die Aufbringung kann genau wie bei der Planarisierungsschicht durch PVD oder CVD, insbesondere PECVD oder LPCVD, oder durch Aufschleudern erfolgen. Es kann auch eine Atomlagenabscheidung (ALD) durchgeführt werden oder ein Transfer-Printverfahren. Vorliegend kommt in Analogie zur Planarisierungsschicht 2 LPCVD zum Einsatz.

Anschließend wird das Beschichtungsmaterial für die Gateelektroden 15a, 15b, Gateelektrodenmaterial, vorliegend Silizium, abgeschieden, beispielsweise mittels PVD oder CVD-Verfahren und bevorzugt ebenfalls flächig.

Es erfolgt eine Lithographie und eine Strukturierung insbesondere mittels reaktivem Ionenätzen (RIE), um die einzelnen Wellenleiter 11 mit den einzelnen Wellenleitersegmente 12a, 12b mit dem jeweils dazwischenliegenden Spalt 14 und die einzelnen Gateelektroden 15a, 15b zu erhalten.

In einem nächsten Schritt S5 wird die weitere Planarisierungsschicht 17 auf den Wellenleitern 11 mit darauf vorgesehenen Gateelektroden 15a, 15b und der Oberseite 10 der Planarisierungsschicht 2 hergestellt. Diese wird vorliegend völlig analog zu der Planarisierungsschicht 2 durch Abscheidung mittels PECVD und Resistplanarisierung erhalten. Bei bzw. aufgrund der Materialabscheidung wird auch der Spalt 14 mit SiO₂ aufgefüllt. Infolge der Resistplanarisierung ergibt sich der im Querschnitt Trapez-förmige Abschnitt der weiteren Planarisierungsschicht 17 oberhalb des Wellenleiters 11 (vgl. Figur 1).

Auch bezüglich der weiteren Planarisierungsschicht 17 gilt, dass alternativ zu LPCVD und CMP andere der vorstehend genannten Verfahren zum Einsatz kommen können und eine andere Planarisierungsbehandlung, etwa CMP, und/oder weitere Planarisierung möglich ist, wie vorstehend für die Planarisierungsschicht 2 beschrieben.

Die Planarisierungsschicht 2 und weitere Planarisierungsschicht 17 können eine oder mehrere Decklagen umfassen, die bevorzugt auf der der Planarisierungsbehandlung unterzogenen Oberfläche vorgesehene sind bzw. werden und bei denen es sich beispielsweise um Dichalkogenidlagen oder Dichalkogenid-Heterostrukturen oder auch Bornitridlagen handeln kann. Diese Materialen werden bevorzugt abgeschieden oder transferiert ohne das es eines weiteren chemisch-mechanischen Polierens oder weiteren Resistplanarisierens bedarf, wobei auch nicht ausgeschlossen ist, dass dies nochmals erfolgt.

Der Vollständigkeit halber sei angemerkt, dass für den Fall, dass eine erfindungsgemäße Halbleitervorrichtung auch Bereiche ohne weitere Planarisierungsschicht 17 aufweisen soll, etwa auch Bereiche, in denen der Aufbau demjenigen gemäß den Figuren 3 bis 6 entspricht, die weitere Planarisierungsschicht 17 (und gegebenenfalls darauf befindliche Schichten) anschließend partiell insbesondere durch Lithographie und ätzen wieder entfernt wird.

In Schritt S6 werden die VIAs 8 durch die Planarisierungsschicht 2 und die weitere Planarisierungsschicht 17 hergestellt. Dies kann prinzipiell auf beliebige aus dem Stand der Technik vorbekannte Weise erfolgen. Insbesondere werden zunächst die Bereiche, in welchen sich diese erstrecken sollen bevorzugt durch Lithographie definiert und mittels RIE trockenchemisch geätzt. Danach wird metallisiert und die metallisierte Oberfläche beispielsweise mittels CMP (Damascene-Prozess) oder mittels Lithografie und RIE strukturiert. Es ist sowohl möglich, dass die VIAs 8 nach der Fertigstellung der weiteren Planarisierungsschicht 17 durch beide Planarisierungsschichten 2, 17 hergestellt werden oder auch nach Fertigstellung der ersten Schicht 2 Abschnitte dieser durch die erste Planarisierungsschicht 10 und nach Fertigstellung der Zweiten 17 Abschnitte dieser durch die zweite Schicht 17.

In Schritt S7 wird das durch einen Graphenfilm 13 gegebenen aktive Element des (jeweiligen) Detektors 3 auf der Oberseite 16 der weiteren Planarisierungsschicht 17 vorgesehen, beispielsweise auf der Oberseite 17 deponiert.

Die Deponierung des Graphenfilms 13 des (jeweiligen) Detektors 3 kann beispielsweise über ein Transferverfahren erfolgen, wie es weiter oben näher beschrieben ist. Dann wird insbesondere jeweils ein auf einem separaten Substrat bzw. einer separaten Metallfolie bzw. einem separaten Germaniumwafer hergestellter Graphenfilm auf die weitere Planarisierungsschicht 17 übertragen. Es ist auch möglich, dass der (jeweilige) Graphenfilm 13 direkt auf der weiteren Planarisierungsschicht 17 hergestellt wird. Dies kann beispielsweise eine Materialabscheidung einschließen.

Kommt ein Transferverfahren zum Einsatz, ist es möglich, dass auf der Oberseite des jeweiligen Graphenfilms 14 bereits die Passivierungsschicht vorgesehen ist, diese etwa darauf abgeschieden oder deponiert wurde, und dann mit diesem transferiert wird. Alternativ dazu kann eine Passivierungsschicht auch nach dem Transferieren bzw. Herstellen des Graphenfilms 13 bzw. der Graphenfilme 13 abgeschieden bzw. deponiert werden.

Es auch ist möglich, dass zunächst ein vollflächiger Graphenfilm und/oder eine vollflächige Passivierungsschicht auf der weiteren Planarisierungsschicht 17 hergestellt wird, die sich über die gesamte Oberfläche der weiteren Planarisierungsschicht 17 erstrecken. In diesem Fall erfolgt dann noch eine Strukturierung, insbesondere durch Lithographie und RIE, um die einzelnen Graphenfilme 13 als aktive Elemente mehrerer Detektoren 3 zu erhalten.

Die Kontaktelemente 18 werden anschließend hergestellt (Schritt S8), bevorzugt, indem Metall vollflächig abgeschieden wird und dann wiederum eine Strukturierung mittels Lithographie und RIE zum Erhalt der einzelnen Elemente 18 erfolgt.

In einem vorletzten Schritt S9 wird die obere Passivierungsschicht 19 vorzugsweise aus Al2O₃ und/oder SiO₂ abgeschieden. In dieser werden dann zweckmäßiger Weise abschließend mittels Lithografie und RIE Öffnungen insbesondere zu Kontaktelementen hergestellt (Schritt S10). Es werden bevorzugt Öffnungen zu Kontaktelementen hergestellt, die der Verbindung der Photonik und/oder Elektronik nach außen dienen.

Die Figur 3 zeigt ein weiteres Ausführungsbeispiel eines Photodetektors 3 gemäß dem ersten Aspekt der Erfindung.

Dieser unterscheidet sich von demjenigen gemäß Figur 1 im Wesentlichen dadurch, dass die beiden Wellenleitersegmente 12a, 12b des Längsabschnitts 12 des Wellenleiters 11 keinen rechteckigen Querschnitt aufweisen und es keine weitere Planarisierungsschicht 17 gibt, sondern das aktive Element, welches auch hier - beispielhaft - durch einen Graphenfilm 13 gegeben ist, auf einer auf den Gateelektroden 15a, 15b vorgesehen, in der Figur nicht erkennbaren dielektrischen Schicht angeordnet ist. Die dielektrische Schicht stellet ein Gatedielektrikum dar. Sie zeichnet sich an ihrer Oberseite vorliegend durch eine Rauheit von 0,2 nm RMS aus. Ihre Dicke beträgt vorliegend 15 nm, wobei diese beiden Werte rein beispielhaft zu verstehen sind.

Wie man erkennt, weist jedes der beiden Wellenleitersegmente 12a, 12b einen dem zwischen den beiden Segmenten 12a, 12b liegenden Spalt 14 zugewandten Endbereich auf, dessen Querschnitt sich in Richtung des Spaltes 14 abschnittsweise verbreitert. Durch die beiden Endbereiche und den Spalt 14 ergibt sich, wie man erkennt, eine zentraler, Trapez-förmiger Bereich. Die sich beidseitig an diesen Trapez-förmigen Bereich anschließenden Abschnitte bzw. Bereiche der Segmente 12a, 12b zeichnen sich, wie man erkennt, durch eine gleichbleibende Dicke aus.

Die beiden Gateelektroden 15a, 15b erstrecken sich in Querrichtung jeweils nur über einen Abschnitt der Oberseite des jeweiligen Segmentes 12a, 12b.

In der Figur 3 sind die den Gateelektroden 15a, 15b zugeordneten, jeweils mit einer Gateelektrode 15a, 15b in Kontakt stehenden VIAs 8 zu erkennen. Über diese wird eine Verbindung zu wenigstens einem integrierten elektronischen Bauteil 5 aus dem FEOL 6 hergestellt, was in der Figur aus Gründen der vereinfachten Darstellung jedoch nicht erkennbar ist. Diese VIAs 8 erstrecken sich, wie man erkennt, jeweils durch die Planarisierungsschicht 2 und dasjenige Wellenleitersegment 12a, 12b, auf dem die jeweilige Gateelektrode 15a, 15b angeordnet ist. Über die VIAs 8 wird die Spannungsversorgung der Gateelektroden 15a, 15b gewährleistet. Auch bei dem Beispiel aus Figur 3 kann über die Gateelektroden 15a, 15b im Betrieb ein pn-Übergang in dem Graphenfilm 13 und zwar auch hier in dem sich oberhalb des Spaltes 14 erstreckenden Bereich, in dem im Betrieb die optische Mode geführt wird, erhalten werden.

Zum Erhalt der Anordnung gemäß Figur 3 können die Schritte S1 bis S3 identisch zu denjenigen für die Herstellung der Anordnung aus Figur 1 sein.

In Schritt S4 wird dabei für die Herstellung der Wellenleiter 11 und Gateelelektroden 15, 15b, nachdem auch hier Wellenleitermaterial flächig abgeschieden wurde, beispielsweise auf die gleiche Weise, wie vorstehend im Zusammenhang mit Figur 1 beschrieben, ein angepasster Ätz-, insbesondere RIE-Prozess durchgeführt, um den Trapez-förmigen Bereich mit den abgeschrägten Kanten zu erhalten. Ein isotropes Ätzverhalten des RIE Prozesses kann beispielsweise durch einen gegenüber dem anisotropen Ätzprozess erhöhten Prozessdruck und angepasstem Gasgemisch erhalten werden. Durch den erhöhten Prozessdruck, beispielsweise 20 mTorr gegenüber 10 mTorr, erhält der Ätzprozess eine ungerichtete Komponente, die an der oberen Kante wegen der längeren Ätzzeit einen höheren Abtrag verursacht. Anschließend werden zunächst die VIAs 8 für die Gateelektroden 15a, 15b hergestellt und dann wird wiederum Material für die Gateelektroden 15a, 15b, etwa Silizium, abgeschieden.

Dann werden der (jeweilige) Slot 14 und die Gateelektroden 15a, 15b geätzt. Dadurch wird die zunächst ganzflächige Gateelektrodenschicht " zerteilt".

Der Schritt S5 für die Anordnung aus Figur 1 entfällt hier, da hier keine weitere Planarisierungsschicht 17 herzustellen ist. Hier werden daher in Schritt S5 die VIAs 8 für den Graphenfilm 13 hergestellt

In Schritt S6 wird zunächst die dielektrische Schicht auf der Oberseite der Gateelektroden 15a, 15b hergestellt und an ihrer Oberseite bevorzugt resistplanarisiert, um die vorgenannte Rauheit zu erzielen, und dann der Graphenfilm 13 darauf vorgesehen.

Die Trapezform begünstigt dabei, dass das aktive Element, vorliegend der Graphenfilm 13, den Gateelektroden 15a, 15b bzw. der dielektrischen Schicht, insbesondere auch den abgeschrägten Kanten, konform folgt. Dadurch liegt das Graphen immer auf der dielektrischen Schicht auf den Elektroden 15a, 15b an und kann besonders gut elektrostatisch kontrolliert werden. Auch kann ein besonders homogenes elektrisches Feld erreicht werden.

Die sich an das Vorsehen des (jeweiligen) Graphenfilms 13 anschließenden Schritte können denjenigen für die Anordnung aus Figur 1 entsprechen (insbesondere Herstellung der Kontaktelemente 18, Herstellung der Passivierungsschicht 19 und Vorsehen von Öffnungen in dieser).

Die Figur 4 zeigt ein Ausführungsbeispiel eines Photodetektors 3 gemäß dem zweiten Aspekt der Erfindung.

Auch dieser umfasst einen Längsabschnitt 12 eines Wellenleiters 11, und ein aktives Element 13, welches wenigsten ein Material umfasst oder aus wenigstens einem Material besteht, das elektromagnetische Strahlung wenigstens einer Wellenlänge absorbiert und infolge der Absorption ein elektrisches Photosignal erzeugt. Auch bei dem Detektor gemäß Figur 3 ist das aktive Element - beispielhaft - durch einen Graphenfilm 13 gegeben.

Im Unterschied zu den Beispielen aus den Figuren 1 und 3 ist der Wellenleiter 11 und dessen zum Detektor 3 gehöriger Längsabschnitt 12 hier einteilig ausgebildet. Es handelt sich konkret um einen Streifenwellenleiter mit rechteckigem Querschnitt.

Ein weiterer Unterschied ist dadurch gegeben, dass zwei Trageelemente 20 an gegenüberliegenden Seiten des Längsabschnitts 12 des Wellenleiters 11 unter Bildung zweier Spalte 21 von diesem beabstandet angeordnet sind. Die Tragelemente 20 sind dabei in Querrichtung von dem Längsabschnitt 12 des Wellenleiters 11 beabstandet angeordnet. Die beiden Spalte 21 sind frei von Material. Vorliegend befindet sich in diesen Vakuum.

Die Tragelemente 20 können aus dem gleichen Material bestehen, wie der Längsabschnitt 12 des Wellenleiters 11, wobei dies beispielhaft zu verstehen ist.

Das aktive Element 13 übergreift, wie man erkennt, in Querrichtung den Längsabschnitt 12 des Wellenleiters 11 und die beiden Spalte 21 und abschnittsweise die beiden Tragelemente 20.

Der Graphenfilm 13 ist ferner - im Gegensatz zu den Beispielen aus den Figuren 1 und 3, wo er in einem Trapez-förmigen Bereich aufliegt - plan.

Was den Wafer 1, die Planarisierungsschicht 2 und die Passivierung 19 angeht, stimmt die Anordnung aus Figur 4 mit derjenigen aus Figur 2 überein. Wie man erkennt, hat diese auch keine weitere Planarisierungsschicht 17. Darüber hinaus umfasst dieser Detektor 3 keine Gateelektroden.

Zur Herstellung der Anordnung aus Figur 4 können die Schritte S1 bis S3 wiederum identisch zu denen sein, die im Zusammenhang mit Figur 1 beschrieben wurden.

In einem Schritt S4 werden dann die Wellenleiter 11 und Trageelemente 20 hergestellt. Hierfür wird Wellenleitermaterial, beispielsweise das gleiche wie bei den vorangegangenen Beispielen, flächig abgeschieden und anschließend die Spalte 21 durch Lithographie und Ätzen erhalten werden.

Dann werden die VIAs 8 hergestellt, die sich hier durch die eine Planarisierungsschicht 2 und jeweils eines der Tragelemente 20 erstrecken (Schritt S5).

In einem Schritt S6 werden die aktiven Elemente, etwa in Form von Graphenfilmen 13 vorgesehen, was zweckmäßiger Weise durch ein Transferverfahren geschieht, wie es vorstehend näher beschrieben ist.

Die verbleibenden Schritte können wieder mit denen übereinstimmen, die sich bei den vorangegangenen Beispielen an das Vorsehen der aktiven Elemente 13 angeschlossen haben (insbesondere Herstellung der Kontaktelemente 18, Herstellung der Passivierungsschicht 19 und Vorsehen von Öffnungen in dieser).

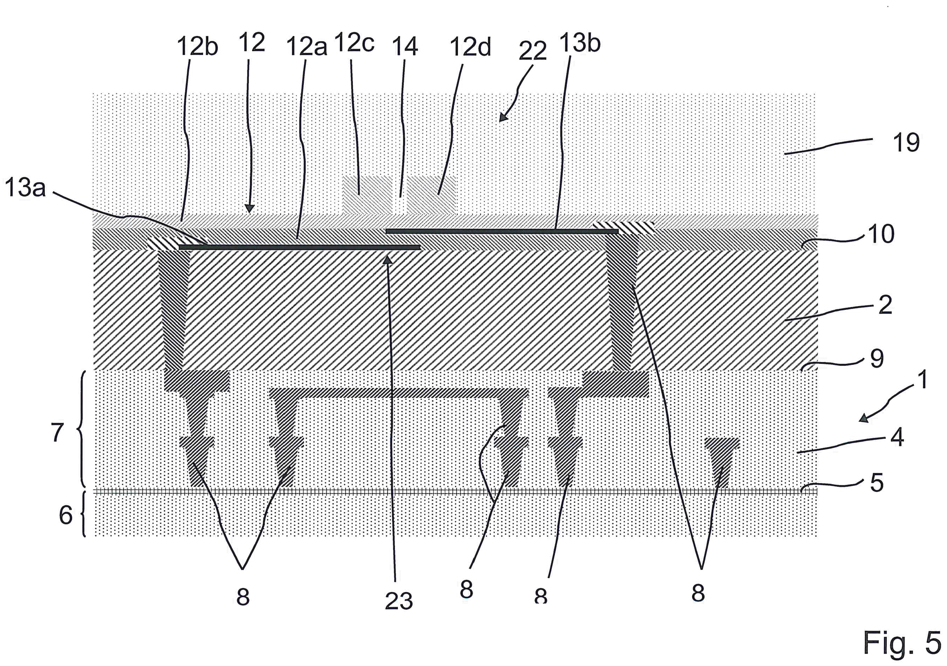

Die Figur 5 zeigt ein Ausführungsbeispiel eines elektro-optischen Modulators 22 gemäß dem dritten Aspekt der Erfindung.

Auch dieser umfasst einen Längsabschnitt 12 eines Wellenleiters 11, der jedoch vier sich in Längsrichtung und zumindest im Wesentlichen parallel zueinander erstreckende Wellenleitersegmente 12a, 12b 12c, 12d umfasst.

Da es sich um einen Modulator 22 handelt, weist dieser ferner zwei aktive Elemente 13a, 13b auf, die wenigsten ein Material umfassen oder aus wenigstens einem Material bestehen, dessen Brechungsindex sich in Abhängigkeit einer Spannung und/oder dem Vorhandensein von Ladung und/oder einem elektrischen Feld ändert. Bei dem gezeigten Beispiel sind die beiden aktiven Elemente durch zwei Graphenfilme 13a, 13b gegeben.

Von den beiden aktiven Elementen 13a, 13b ist das untere 13a auf der Oberseite 10 der Planarisierungsschicht 2 angeordnet.

Es sei angemerkt, dass alternativ dazu, dass zwei aktive Elemente 13a, 13b vorgesehen sind, auch nur ein aktives Element und eine konventionelle Elektrode, etwa aus einem Metall, vorgesehen sein und entsprechend zueinander angeordnet sein können.

Bezüglich der vier Wellenleitersegmente 12a-12d gilt ferner, dass ein unteres der Wellenleitersegmente 12a zwischen den beiden aktiven Elemente 13a, 13b angeordnet ist und ein mittleres der Wellenleitersegmente 12b oberhalb der beiden aktiven Elemente 13a, 13b, konkret auf dem oberen aktiven Element 13b angeordnet ist. Es liegt mit anderen Worten eine sandwichartige Konfiguration mit bzw. aus (in Figur 5 von unten nach oben) erstem aktivem Element 13a, unterem Wellenleitersegment 12a, zweiten aktiven Element 13b und mittlerem Segment 12b vor. Das obere aktive Element 13 erstreckt sich innerhalb des Längsabschnitts 12 des Wellenleiters. Die Wellenleitersegmente 12a-12d können alle aus dem gleichen Material sein.

Das untere und das mittlere Wellenleitersegment 12a, 12b dienen gleichzeitig als Passivierung und Ätzschutz. Insbesondere ist das Segment 12a Teil des Wellenleiters und gleichzeitig auch Schutz für das Element 13a wenn das Element 13b geätzt wird. Dann dient 12a als Ätzstoppschicht und als Passivierungsschicht um das Graphen 13a zu schützen. Das Segment 12b ist insbesondere auch Ätzstopschicht für die Strukturierung der Teile 12c und 12d bei der Herstellung des Bereichs 14.

Die beiden verbleibenden, oberen Wellenleitersegmente 12c, 12d sind oberhalb des mittleren Wellenleitersegmentes 12b, vorliegend auf dessen Oberseite angeordnet. Die beiden oberen Wellenleitersegmente 12c, 12d sind in Querrichtung unter Bildung eines sich zwischen ihnen erstreckenden Spaltes 14 voneinander beabstandet. Die beiden oberen Wellenleitersegmente 12c, 12d liegen somit nebeneinander auf dem mittleren Segment 12b und der Spalt 14 liegt zwischen diesen. Es gilt, dass genau eine Spalt 14 oberhalb der beiden aktiven Elemente 13 vorgesehen ist. Der Spalt 14 ist mit dem Material der Schicht 19 aufgefüllt.

Die Ausdehnung des unteren und mittleren Wellenleitersegmentes 12a, 12b in Querrichtung übersteigt, wie man erkennt, die Ausdehnung der beiden oberen Segmente 12c, 12d in dieser Richtung um ein Vielfaches. Der Querschnitt der Segmente 12a-12d ist rechteckig.

Die beiden aktiven Elemente 13a, 13b sind - durch das untere Wellenleitersegment 12a - voneinander beabstandet und darüber hinaus in Querrichtung derart versetzt zueinander angeordnet, dass sie in einem Überlappungsbereich 23 abschnittsweise übereinander liegen. Es fluchtet bzw. überlappt dein Abschnitt des einen aktiven Elementes 13 mit einem Abschnitt des anderen aktiven Elementes 13. Konkret liegen die einander zugewandten Endbereiche übereinander bzw. fluchten, wodurch der Überlappungsbereich 23 gebildet wird. Der Überlappungsbereich 23 liegt, wie man der Figur 5 entnehmen kann, unterhalb des zwischen den beiden Segmenten 12c, 12d gebildeten Spaltes 14, fluchtet mit diesem.

Die Ausdehnung des Überlappungsbereiches 23 und die Ausdehnung des Spaltes 14 in Querrichtung sind aneinander angepasst. Konkret beträgt die Ausdehnung des Überlappungsbereiches 23 in Querrichtung in etwa dem 1,3fachen der Ausdehnung des Spaltes 14 in dieser Richtung. Sie kann beispielsweise auch dem 1,0-fachen oder 0,8-fachen entsprechen, also die gleiche oder eine geringere Ausdehnung in dieser Richtung aufweisen. Es gilt insbesondere, dass, je kleiner die Überlappung, desto geringer ist die Kapazität und desto schneller ist der Modulator.

Auch im Falle des Modulators 22 mit zwei aktiven Elementen 13 gilt, dass dieser, konkret dessen aktiven Elemente 13, mit wenigstens einem integrierten elektronischen Bauteil 5 aus dem FEOL des Wafers 1 verbunden sind. Dabei ist jedes aktive Element 13 über ein diesem zugeordnetes, mit diesem in Kontakt stehendes Kontaktelement 18 mit einem VIA 8 verbunden, der sich durch die Planarisierungsschicht 2 (VIA 8 für das in Figur 5 linke aktive Element 13) bzw. die Planarisierungsschicht 2 und das Wellenleitersegment 12a (VIA 8 für das in Figur 5 rechte aktive Element 13) erstreckt und zusammen mit weitere VIAs 8 im BEOL 7 die Verbindung gewährleistet.

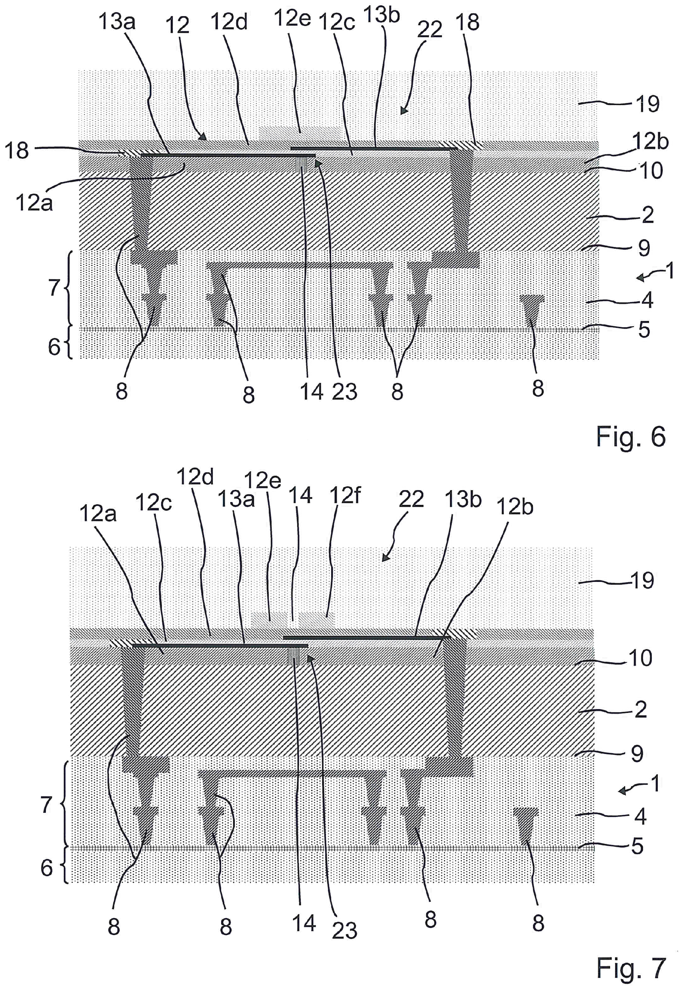

Ein elektro-optischer Modulator 22, wie er in Figur 5 und auch den im Weiteren noch erläuterten Figuren 6 und 7 gezeigt ist, kann in an sich bekannter Weise insbesondere zur optischen Signalcodierung verwendet werden.

Zum Erhalt der Anordnung aus Figur 5 können die Schritte S1 bis S3 wiederum identisch sein.

Im Anschluss daran kann in einem Schritt S4 der erste, untere Graphenfilm 13a als unteres aktives Element vorgesehen werden. Dies kann genauso erfolgen, wie vorstehend für das eine aktive Element 13 der Detektoren 3 beschrieben. Dies kann entsprechend beispielsweise eine vollflächige Abscheidung von Material und anschließende Strukturierung umfassen.

Dann kann das zu diesem gehörige Kontaktelement 18 hergestellt werden, wiederum genauso, wie die Kontaktelemente 18 aus den Figuren 1, 3 und 4.

In Schritt S6 wird dann das untere Wellenleitersegment 12a hergestellt, was bevorzugt - in Analogie zu den Segmenten 12a, 12b aus den vorangegangenen Figuren - eine Materialabscheidung und anschließende Strukturierung umfassen kann. Als Wellenleitermaterial kommen die gleichen Materialien in Frage, die zu den vorangegangenen Beispielen genannt wurden.

In Schritt S7 wird auf der Oberseite des Segmentes 12a der zweite, obere Graphenfilm 13b vorgesehen, bevorzugt auf die gleiche Weise wie das erste, untere 13a.

In Schritt S8 wir das Kontaktelement 18 für diesen hergestellt.

In Schritt S9 wird das mittlere Segment 12b - bevorzugt wie das untere 12a - hergestellt und in Schritt S10 die beiden oberen Segmente 12c, 12d auf der Oberseite des mittleren Segments 12c. Auch hier gilt, dass ein Wellenleitermaterial auf die vorstehend beschriebene Weise abgeschieden werden und anschließend eine Strukturierung zum Erhalt der beiden nebeneinanderliegenden, den Spalt 14 zwischen sich einschließenden Segmenten 12c, 12d erfolgen kann. Es sei angemerkt, dass es möglich ist, dass die Materialabscheidung für das mittlere Segment 12b und die oberen beiden Segmente 12c, 12d mit Unterbrechung bzw. separat erfolgt, dies beispielsweise, wenn verschiedene Wellenleitermaterialien verwendet werden. Es ist aber auch nicht ausgeschlossen, dass das für das mittlere Segment 12b erforderliche Material und das für die oberen Segmente 12c, 12d erforderliche Material in einem Abscheidungsvorgang, ohne Unterbrechung aufgebracht wird und die Segmente 12b, 12c, 12d durch die anschließender Strukturierung erhalten werden.

Daran schließen sich dann bevorzugt die Schritte zum Erhalt der Passivierungsschicht 19 (S11) und der Öffnungen in dieser an (S12), wie sie vorstehend im Zusammenhang mit den vorangegangenen Figuren erläutert wurden. Der Spalt 14 füllt sich bei bzw. aufgrund der Materialabscheidung für die Schicht 19 mit deren Material.

In der Figur 6 ist ein Ausführungsbeispiel eines Modulators 22 gemäß dem vierten Aspekt der Erfindung gezeigt.

Dieser unterscheidet sich von demjenigen gemäß Figur 5 im Wesentlichen dadurch, dass sich nicht oberhalb, sondern unterhalb der aktiven Elemente 13, die hier ebenfalls - beispielshaft - durch Graphenfilme 13 gegeben sind, ein Spalt 14 befindet und der Längsabschnitt 12 des Wellenleiters 11 nicht vier, sondern fünf Segmente 12a, 12b, 12c, 12d, 12e umfasst.

Konkret sind zwei untere der Wellenleitersegmente 12a, 12b unterhalb der aktiven Elemente 13 angeordnet und in Querrichtung unter Bildung eines sich zwischen ihnen erstreckenden Spaltes 14 voneinander beabstandet, und ein erstes mittleres der Wellenleitersegmente 12c ist zwischen den beiden aktiven Elementen 13 angeordnet, und ein zweites mittleres Wellenleitersegment 12d ist oberhalb der beiden aktiven Elemente 13, konkret auf der Oberseite des oberen aktiven Elementes 13 angeordnet, und ein oberes Wellenleitersegment 12e ist oberhalb des zweiten mittleren Wellenleitersegments 12d, konkret auf dessen Oberseite angeordnet. Bei diesem Beispiel liegt somit ein sandwichartiger Aufbau vor, der - von unten nach oben - die beiden unteren Wellenleitersegmente 12a, 12b, das untere aktive Element 13a, ein erstes mittleres Wellenleitersegment 12c, das obere aktive Element 13b, ein zweites mittleres Wellenleitersegment 12d und auf dessen Oberseite das obere Wellenleitersegment 12e umfasst. Hier erstrecken sich beide aktiven Elemente 13 innerhalb des Längsabschnitts 12 des Wellenleiters 11.

Die beiden unteren Wellenleitersegmente 12a, 12b und das erste mittlere Wellenleitersegment 12c dienen auch hier gleichzeitig als Passivierung und Ätzschutz.

Für die Ausdehnung des Spaltes 14 in des Überlappungsbereiches 23 in Querrichtung gilt das gleiche wie bezüglich Figur 5.

Zum Erhalt der Anordnung aus Figur 5 können die Schritte S1 bis S3 wiederum identisch sein.

In einem Schritt S4 werden dann auf der Oberseite 10 der Planarisierungsschicht 2 zunächst die beiden Wellenleitersegmente 12a, 12b hergestellt, wobei hierzu Wellenleitermaterial abgeschieden wird, bevorzugt genauso wie bei den vorangegangenen Beispielen, wodurch sich zunächst eine durchgehende Schicht ergibt, und dann durch Strukturierung, die bevorzugt Lithographie und Ätzen, insbesondere RIE einschließt, der Spalt 14 hergestellt, mit einem dielektrischen Material, etwa SiO₂, aufgefüllt und die Oberfläche bevorzugt planarisiert wird, etwa durch CMP und/oder Resistplanarisierung.

Dann kann der dem in Figur 5 linken Graphenfilm 13 zugeordnete VIA 8 hergestellt werden (Schritt S5), der sich durch die Planarisierungsschicht 2 und das in Figur 5 linke der unteren Segmente 12a erstreckt, was wie vorstehend beschrieben erfolgen kann.

Als nächstes wird der erste, untere Graphenfilm 13 vorgesehen (Schritt S6), was ebenfalls wie bei den vorangegangenen Beispielen erfolgen kann. Der untere Graphenfilm 13 wird dabei bevorzugt derart angeordnet, dass er den Spalt 14 - wie in Figur 5 erkennbar - in Querrichtung vollständig übergreift.

Dann kann das zugehörige Kontaktelement 18, wie vorstehend beschrieben, hergestellt werden (Schritt S6) und dann das erste mittlere Wellenleitersegment 12c, dann der VIA 8 für den zweiten, oberen Graphenfilm 13 (Schritt S7), dann der zweite, obere Graphenfilm 13 (S8), wie der erste, dann das zweite mittlere Segment 12d (S9) und das obere Segment 12e (S10). Die Herstellung der Segmente 12c, 12d und 12e kann dabei beispielsweise analog zur Herstellung der Segmente 12a bis 12d aus Figur 5 erfolgen, mit dem Unterschied, dass in dem Segment 12e kein Spalt vorgesehen, sondern dieses nur als streifenförmiges Segment mit rechteckigem Querschnitt geätzt wird.

Abschließend können auch hier die vorstehend beschriebenen Schritte zum Erhalt der Passivierungsschicht 19 (S11) und der Öffnungen in dieser (S12) durchgeführt werden.

In Figur 7 ist ein Ausführungsbeispiel eines Modulators 22 gemäß dem fünften Aspekt der Erfindung gezeigt.

Dieser unterscheidet sich von dem Beispiel aus Figur 6 alleine dadurch, dass zusätzlich oberhalb der wiederum beispielhaft durch Graphenfilme 13 gegebenen aktiven Elemente ein zweiter Spalt 14 vorgesehen ist. Anstelle des streifenförmigen Wellenleitersegmentes 12e wie in Figur 6 sind hier auch oberhalb der Graphenfilme 13 zwei nebeneinanderliegende, voneinander unter Bildung des zweiten Spaltes 14 beabstandete Segmente 12e und 12f auf der Oberseite des zweiten mittleren Segmentes 12d vorgesehen. Es sei angemerkt, dass sich der zweite, obere Spalt 14 auch hier bei bzw. aufgrund der Materialabscheidung für die Schicht 19 mit deren Material füllt.

Bei diesem Beispiel liegt ein sandwichartiger Aufbau vor, der - von unten nach oben - die beiden unteren Wellenleitersegmente 12a, 12b, das untere aktive Element 13a, ein erstes mittleres Wellenleitersegment 12c, das obere aktive Element 13b, ein zweites mittleres Wellenleitersegment 12d und auf dessen Oberseite zwei nebeneinanderliegende, obere Wellenleitersegmente 12e, 12f umfasst. Auch hier erstrecken sich beide aktiven Elemente 13 innerhalb des Längsabschnitts 12 des Wellenleiters 11.

Die beiden unteren Wellenleitersegmente 12a, 12b und das erste mittlere Wellenleitersegment 12c dienen auch hier gleichzeitig als Passivierung und Ätzschutz.

Wie man in der Figur 6 erkennt, liegt der Überlappungsbereich 23, den die beiden aktiven Elemente 13 aufgrund des Versatzes bilden, oberhalb des einen Spaltes 14, konkret desjenigen zwischen den unteren Segmenten 12a und 12b, und unterhalb des anderen Spaltes 14, konkret desjenigen zwischen den oberen Segmenten 12e und 12f.

Der untere Spalt 14, der Überlappungsbereich 23 und der obere Spalt 14 fluchten.

Es gilt ferner auch hier, dass die Ausdehnung des Überlappungsbereiches 23 und die Ausdehnung beider Spalte 14 in Querrichtung aneinander angepasst sind. Konkret beträgt die Ausdehnung des Überlappungsbereiches 23 in Querrichtung in etwa dem 1,3fachen der Ausdehnung des oberen Spaltes 14 und des unteren Spaltes 14 in dieser Richtung. Sie kann beispielsweise auch dem 1,0-fachen oder 0,8-fachen entsprechen.

Zum Erhalt der Anordnung aus Figur 7 kann genauso vorgegangen werden, wie für die aus Figur 6, mit dem einzigen Unterschied, dass zusätzlich der obere Spalt 14 geätzt werden muss. Dadurch werden dann auf der Oberseite des zweiten mittleren Wellenleitersegmentes 12d anstelle des einen oberen Segmentes 12e die beiden oberen Segmente 12e und 12f mit dem Spalt 14 dazwischen erhalten.

Wie vorstehend angemerkt umfassen die Beispiele erfindungsgemäßer Halbleitervorrichtungen jeweils mehrere Photodetektoren 3 bzw. Modulatoren 22, von denen die Teilschnitte nur beispielhaft einen zeigen. Bei den dargestellten Ausführungsbeispielen erfindungsgemäßer Halbleitervorrichtungen können jeweils alle Photodetektoren 3 bzw. Modulatoren 22 baugleich sein. Die Übereinstimmung ermöglicht dann eine besonders einfache, zügige Herstellung. Es sei jedoch betont, dass es selbstverständlich auch möglich ist, dass eine erfindungsgemäße Halbleitervorrichtung verschiedene der in den Figuren 1 bzw. 3 bis 6 dargestellten Beispiele von Photodetektoren 3 und/oder Modulatoren 22 umfasst, etwa sowohl Detektoren 3 gemäß Figur 1 als auch Modulatoren gemäß Figur 5. Dabei können auch mehr als zwei verschiedene der Beispiele vorhanden sein, beispielsweise auch von allen gezeigten Photodetektoren 3 und/oder von allen gezeigten Modulatoren 22 jeweils einer oder jeweils mehrere.

Es sei angemerkt, dass die jeweils auf dem Wafer 1 vorgesehenen Anordnungen, welche die Schichten 2, ggf. 17 und 19 sowie Photodetektoren 3 und/oder Modulatoren 22 umfassen, auch jeweils als photonische Plattform erachtet und bezeichnet werden können. Weiterhin sein angemerkt, dass alternativ dazu, dass die photonische Plattform wie bei dem beschriebenen Ausführungsbeispielen jeweils auf dem BEOL 7 des Wafers 1 hergestellt wird, es prinzipiell auch möglich ist, dass diese separat gefertigt und mit dem Wafer 1 gebondet wird.

Nach der Fertigstellung einer erfindungsgemäßen Halbleitervorrichtung kann aus dieser auf einfache und schnelle Weise, konkret durch bloßes Dicen, mit anderen Worten Zerkleinern, eine Vielzahl von Halbleitereinrichtungen, die jeweils durch einen Chip mit integrierter, darauf aufgebauter Photonik mit einem oder mehreren Photodetektoren 3 und/oder Modulatoren 22 gemäß der vorliegenden Erfindung gebildet sind, erhalten werden.

Die durch das Dicen erhaltenen " Nacktchips " mit Photodetektoren 3 und/oder Modulatoren 22 können dann, wie es auch von herkömmlichen Nacktchips vorbekannt ist, in Gehäuse (englisch: Packages) eingesetzt und einer weiteren Nutzung zugeführt werden.

Ein durch Dicen der Halbleitervorrichtung mit dem Wafer 1 und den Photodetektoren 3 und/oder Modulatoren 22 erhaltener Chip mit einem oder mehreren solcher ist ein Ausführungsbeispiel einer erfindungsgemäßen Halbleitereinrichtung.

Es sei angemerkt, dass sämtliche Teilschnittdarstellungen nur einen vergleichsweise sehr kleinen Ausschnitt zeigen, konkret einen Ausschnitt, der nur einen kleinen Teil des Wafers 1 bzw. eines nach dem Dicen erhaltenen Chips zeigt. Sämtliche Teilschnitte repräsentieren somit Schnitte sowohl durch ein Ausführungsbeispiel einer erfindungsgemäßen Halbleitervorrichtung als auch durch ein Ausführungsbeispiel einer erfindungsgemäßen Halbleitereinrichtung. Weiterhin sei angemerkt, dass bereits oberhalb eines einzelnen Chips eine Mehrzahl von Photodetektoren 3 und/oder Modulatoren 22 vorgesehen sein bzw. werden kann, je nach Anwendungsfall beispielsweise mehrere zehn, mehrere hundert oder sogar mehrere tausend.

## Patentansprüche

1. Photodetektor (3) umfassend einen Längsabschnitt (12) eines Wellenleiters (11), der zwei sich in Längsrichtung und zumindest im Wesentlichen parallel zueinander erstreckende Wellenleitersegmente (12a, 12b), die bevorzugt in Querrichtung unter Bildung eines sich zwischen ihnen erstreckenden Spaltes (14) voneinander beabstandet sind, umfasst oder dadurch gebildet wird, und ein aktives Element (13), welches den Längsabschnitt (12) des Wellenleiters übergreift und wenigsten ein Material umfasst oder aus wenigstens einem Material besteht, das elektromagnetische Strahlung wenigstens einer Wellenlänge absorbiert und infolge der Absorption ein elektrisches Photosignal erzeugt, wobei die beiden Wellenleitersegmente (12a, 12b) jeweils an wenigstens einer Seite, insbesondere an der dem aktiven Element (14) zugewandten Seite zumindest abschnittsweise mit einer bevorzugt Silizium umfassenden oder aus Silizium bestehenden Gateelektrode (15a, 15b) in Kontakt stehen.

2. Photodetektor (3) nach Anspruch 1, **dadurch gekennzeichnet, dass** die Gateelektroden (15a, 15b) jeweils an ihrer Unterseite mit der Oberseite eines Wellenleitersegmentes (12a, 12b) und jeweils mit ihrer Oberseite mit der Unterseite einer zwischen dem aktiven Element (13) und den Wellenleitersegmenten (12a, 12b) vorgesehenen dielektrischen Schicht in Kontakt stehen, und/oder dass die Gateelektroden (15a, 15b) ein für elektromagnetische Strahlung wenigstens einer Wellenlänge transparentes und/oder elektrisch leitfähiges Material umfassen oder daraus bestehen.

3. Photodetektor (3) nach einem der vorhergehenden Ansprüche, **dadurch gekennzeichnet, dass** jeder der beiden Gateelektroden (15a, 15b) ein mit dieser in Kontakt stehendes Verbindungselement (8) zugeordnet ist und sich jeweils eines der Verbindungselemente (8) durch eines der Wellenleitersegmente (12a, 12b) erstreckt, und/oder dass das aktive Element (13) die beiden Wellenleitersegmente (12a, 12b) und den dazwischenliegenden Spalt (14) zumindest abschnittsweise übergreift.

4. Photodetektor (3) nach einem der vorhergehenden Ansprüche, **dadurch gekennzeichnet, dass** es sich bei dem wenigstens einen Material des aktiven Elementes (13), das elektromagnetische Strahlung wenigstens einer Wellenlänge absorbiert und infolge der Absorption ein elektrisches Photosignal erzeugt, um Graphen, und/oder wenigstens ein Dichalkogenid, insbesondere zweidimensionales Übergangs-Dichalkogenid, und/oder Heterostrukturen aus zweidimensionalen Materialien und/oder Germanium und/oder wenigstens ein elektro-optisches Polymer und/oder Silizium und/oder wenigstens einen Verbindungshalbleiter, insbesondere wenigsten einen III-V-Halbleiter und/oder wenigstens einen II-VI-Halbleiter, handelt.

5. Modulator (22) umfassend einen Längsabschnitt (12) eines Wellenleiters (11), der vier sich in Längsrichtung und zumindest im Wesentlichen parallel zueinander erstreckende Wellenleitersegmente (12a, 12b, 12c, 12d) umfasst oder durch diese gebildet wird, und zwei aktive Elemente (13), die wenigsten ein Material umfassen oder aus wenigstens einem Material bestehen, dessen Brechungsindex sich in Abhängigkeit einer Spannung und/oder dem Vorhandensein von Ladung und/oder einem elektrischen Feld ändert, oder ein solches aktives Element (13) und eine Elektrode, wobei ein unteres der Wellenleitersegmente (12a) zwischen den beiden aktiven Elemente (13) oder zwischen dem aktiven Element (13) und der Elektrode angeordnet ist, ein mittleres der Wellenleitersegmente (12b) oberhalb der beiden aktiven Elemente (13) oder oberhalb des aktiven Elementes (13) und der Elektrode angeordnet ist, und die beiden verbleibenden, oberen Wellenleitersegmente (12c, 12d) oberhalb des mittleren Wellenleitersegmentes (12b) angeordnet sind, wobei die beiden oberen Wellenleitersegmente (12c, 12d) bevorzugt in Querrichtung unter Bildung eines sich zwischen ihnen erstreckenden Spaltes (14) voneinander beabstandet sind.

6. Modulator (22) umfassend einen Längsabschnitt (12) eines Wellenleiters (11), der fünf sich in Längsrichtung und zumindest im Wesentlichen parallel zueinander erstreckende Wellenleitersegmente (12a, 12b, 12c, 12d, 12e) umfasst oder durch diese gebildet wird, und zwei aktive Elemente (13), die wenigsten ein Material umfassen oder aus wenigstens einem Material bestehen, dessen Brechungsindex sich in Abhängigkeit einer Spannung und/oder dem Vorhandensein von Ladung und/oder einem elektrischen Feld ändert, oder ein solches aktives Element (13) und eine Elektrode, wobei zwei untere der Wellenleitersegmente(12a, 12b) unterhalb der aktiven Elemente (13) oder unterhalb des aktiven Elementes (13) und der Elektrode angeordnet und bevorzugt in Querrichtung unter Bildung eines sich zwischen ihnen erstreckenden Spaltes (14) voneinander beabstandet sind, und ein erstes mittleres der Wellenleitersegmente (12c) zwischen den beiden aktiven Elementen (13) oder zwischen dem aktiven Element (13) und der Elektrode angeordnet ist, und ein zweites mittleres Wellenleitersegment (12d) oberhalb der beiden aktiven Elemente (13) oder oberhalb des aktiven Elementes (13) und der Elektrode angeordnet ist, und ein oberes Wellenleitersegment (12e) oberhalb des zweiten mittleren Wellenleitersegments (12d) angeordnet ist.

7. Modulator (22) umfassend einen Längsabschnitt (12) eines Wellenleiters (11), der sechs sich in Längsrichtung und zumindest im Wesentlichen parallel zueinander erstreckende Wellenleitersegmente (12a, 12b, 12c, 12d, 12e, 12f) umfasst oder durch diese gebildet wird, und zwei aktive Elemente (13), die wenigsten ein Material umfassen oder aus wenigstens einem Material bestehen, dessen Brechungsindex sich in Abhängigkeit einer Spannung und/oder dem Vorhandensein von Ladung und/oder einem elektrischen Feld ändert, oder ein solches aktives Element (13) und eine Elektrode, wobei zwei untere der Wellenleitersegmente (12a, 12b) unterhalb der aktiven Elemente (13) oder unterhalb des aktiven Elementes (13) und der Elektrode angeordnet und bevorzugt in Querrichtung unter Bildung eines sich zwischen ihnen erstreckenden Spaltes (14) voneinander beabstandet sind, und ein erstes mittleres der Wellenleitersegmente (12c) zwischen den beiden aktiven Elementen (13) oder zwischen dem aktiven Element (13) und der Elektrode angeordnet ist, und ein zweites mittleres Wellenleitersegment (12d) oberhalb der beiden aktiven Elemente (13) oder oberhalb des aktiven Elementes (13) und der Elektrode angeordnet ist, und die beiden verbleibenden, oberen Wellenleitersegmente (12e, 12f) oberhalb des zweiten mittleren Wellenleitersegmentes (12d) angeordnet sind, wobei die beiden oberen Wellenleitersegmente (12e, 12f) bevorzugt in Querrichtung unter Bildung eines sich zwischen ihnen erstreckenden Spaltes (14) voneinander beabstandet sind.

8. Modulator (22) nach einem der Ansprüche 5 bis 7, **dadurch gekennzeichnet, dass** die beiden aktiven Elemente (13) oder das aktive Element (13) und die Elektrode voneinander beabstandet und derart versetzt zueinander angeordnet sind, dass sie in einem Überlappungsbereich (23) abschnittsweise übereinander liegen.

9. Modulator (22) nach Anspruch 5 oder 6 und Anspruch 8, **dadurch gekennzeichnet, dass** der Überlappungsbereich (23) oberhalb oder unterhalb des Spaltes (14) liegt.

10. Modulator (22) nach Anspruch 7 und 8, **dadurch gekennzeichnet, dass** der Überlappungsbereich (23) oberhalb des einen und unterhalb des anderen Spaltes (14) liegt.

11. Modulator (22) nach einem der Ansprüche 5 bis 10, **dadurch gekennzeichnet, dass** oberhalb der beiden aktiven Elemente (13) oder oberhalb des aktiven Elementes und der Elektrode genau ein zwischen zwei beabstandeten Wellenleitersegmenten (12a-12f) gebildeter Spalt (14) vorgesehen ist und/oder dass unterhalb der beiden aktiven Elemente (13) oder unterhalb des aktiven Elementes (13) und der Elektrode genau ein zwischen zwei beabstandeten Wellenleitersegmenten (12a-12f) gebildeter Spalt (14) vorgesehen ist, und/oder dass die Ausdehnung des Überlappungsbereiches (23) in Querrichtung im Bereich vom 0,8-fachen bis 1,8-fachen, bevorzugt 1,0-fachen bis 1,5-fachen der Ausdehnung des oder wenigstens eines der Spalte (14) in Querrichtung entspricht, und/oder dass es sich bei dem wenigstens einen Material wenigstens eines der aktiven Elemente (13), dessen Brechungsindex sich in Abhängigkeit einer Spannung und/oder dem Vorhandensein von Ladung und/oder einem elektrischen Feld ändert, um Graphen, und/oder wenigstens ein Dichalkogenid, insbesondere zweidimensionales Übergangs-Dichalkogenid, und/oder Heterostrukturen aus zweidimensionalen Materialien und/oder Germanium und/oder Lithiumniobad und/oder wenigstens ein elektro-optisches Polymer und/oder Silizium und/oder wenigstens einen Verbindungshalbleiter, insbesondere wenigsten einen III-V-Halbleiter und/oder wenigstens einen II-VI-Halbleiter, handelt.

12. Photodetektor (3) oder Modulator (22) nach einem der vorhergehenden Ansprüche, **dadurch gekennzeichnet, dass** der Längsabschnitt (12) des Wellenleiters (11) auf oder oberhalb einer Planarisierungsschicht (2, 17) angeordnet ist, wobei bevorzugt sich die Planarisierungsschicht (2, 17) an derjenigen Seite, an welcher der Längsabschnitt (12) des Wellenleiters (11) auf dieser angerordnet ist zumindest abschnittsweise durch eine Rauheit im Bereich von 1,0 nm RMS bis 0,1 nm RMS, insbesondere 0,6 nm RMS bis 0,1 nm RMS, bevorzugt 0,4 nm RMS bis 0,1 nm RMS auszeichnet, und/oder dass der Längsabschnitt (12) des Wellenleiters (11) zumindest abschnittsweise in eine Planarisierungsschicht (2, 17) eingebettet ist, und das aktive Element (13) oder eines der aktiven Elemente (13) auf der Planarisierungsschicht (2, 17) angeordnet ist, wobei bevorzugt sich die Planarisierungsschicht (2, 17) an derjenigen Seite, an welcher das aktive Element (13) auf dieser angerordnet ist zumindest abschnittsweise durch eine Rauheit im Bereich von 1,0 nm RMS bis 0,1 nm RMS, insbesondere 0,6 nm RMS bis 0,1 nm RMS, bevorzugt 0,4 nm RMS bis 0,1 nm RMS auszeichnet.

13. Photodetektor (3) oder Modulator (22) nach einem der vorhergehenden Ansprüche, **dadurch gekennzeichnet, dass** der Längsabschnitt (12) des Wellenleiters (11) Titandioxid und/oder Aluminiumnitrid und/oder Tantalpentoxid und/oder Siliziumnitrid und/oder Aluminiumoxid und/oder Siliziumoxynitrid und/oder Lithiumniobat und/oder Silizium, insbesondere Polysilizium, und/oder Indiumphosphit und/oder Galliumarsenid und/oder Indiumgalliumarsenid und/oder Aluminiumgalliumarsenid und/oder wenigstens ein Dichalkogenid, insbesondere zweidimensionales Übergangsmetall-Dichalkogenid, und/oder Chalkogenidglas und/oder Heterostrukturen aus zweidimensionalen Materialien und/oder Harze bzw. Harz enthaltende Materialien, insbesondere SU8, und/oder Polymere bzw. Polymere enthaltende Materialien, insbesondere OrmoClad und/oder OrmoCore, umfasst oder daraus besteht.

14. Halbleitereinrichtung umfassend einen Chip und wenigstens einen, bevorzugt mehrere Photodetektoren (3) und/oder Modulatoren (22) nach einem der Ansprüche 1 bis 13, wobei der oder die Photodetektoren (3) und/oder Modulatoren (22) bevorzugt auf dem Chip oder auf einer auf dem Chip oder oberhalb des Chips angeordneten Schicht angeordnet sind, insbesondere, wobei der Photodetektor (3) und/oder Modulator (22) Bestandteil einer auf dem Chip hergestellten oder mit dem Chip gebondeten photonischen Plattform ist.

15. Halbleitervorrichtung umfassend einen Wafer (1) und wenigstens einen, bevorzugt mehrere Photodetektoren (3) und/oder Modulatoren (22) nach einem der Ansprüche 1 bis 13, wobei der oder die Photodetektoren (3) und/oder Modulatoren (22) bevorzugt auf dem Wafer (1) oder auf einer auf dem Wafer (1) oder oberhalb des Wafers (1) angeordneten Schicht (2) angeordnet sind, insbesondere, wobei der Photodetektor (3) und/oder Modulator (22) Bestandteil einer auf dem Wafer (1) hergestellten oder mit dem Wafer (1) gebondeten photonischen Plattform ist.
